# FASCICULE DE BREVET EUROPEEN

(11) **EP 1 495 496 B1**
(45) Date de publication et mention de la délivrance du brevet: **18.11.2009**
(21) Numéro de dépôt: 03709915.7
(22) Date de dépôt: 31.01.2003
(51) Int. Cl.: H01L 29/788, H01L 27/115

(54) **DISPOSITIF SEMICONDUCTEUR DE MEMOIRE, NON VOLATILE, PROGRAMMABLE ET EFFACABLE ELECTRIQUEMENT, A UNE SEULE COUCHE DE MATERIAU DE GRILLE, ET PLAN MEMOIRE CORRESPONDANT**
ELEKTRISCH LÖSCHBARE UND PROGRAMMIEBARE NICHTFLÜCHTIGE HALBLEITERSPEICHERANORDNUNG MIT EINSCHICHTIGEM GATEMATERIAL UND ENTSPRECHENDE SPEICHERFLÄCHE
NON-VOLATILE, PROGRAMMABLE, ELECTRICALLY ERASABLE MEMORY SEMICONDUCTOR DEVICE HAVING A SINGLE GRID MATERIAL LAYER AND CORRESPONDING MAGNETIC CORE PLANE

(30) Priorité: 15.04.2002 FR 0204690; 25.07.2002 FR 0209454
(43) Date de publication de la demande: 12.01.2005
(73) Titulaire: STMicroelectronics S.A., 92120 Montrouge (FR)
(72) Inventeur: GENDRIER, Philippe, F-3800 Grenoble (FR); DRAY, Cyrille, F-38320 Evens (FR); FOURNEL, Richard, F-38660 Lumbin (FR); POIRIER, Sébastien, F-38220 Vizille (FR); CASPAR, Daniel, F-38666 Saint Hilaire du Touvet (FR); CANDELIER, Philippe, F-38190 Sait Mury Monteymond (FR)
(74) Mandataire: Casalonga, Axel
(86) Numéro de dépôt international: PCT/FR2003/000311
(87) Numéro de publication internationale: WO 2003/088366

(56) Documents cités:
- EP-A- 0 623 959
- WO-A-00/60672
- US-A- 5 761 121
- US-A- 6 025 625

## Description

L'invention concerne les circuits intégrés, et plus particulièrement les dispositifs semiconducteurs de mémoire du type non volatiles, programmables et effaçables électriquement à une seule couche de matériau de grille.

La structure d'un tel point mémoire est bien connue de l'homme du métier. Le brevet américain n° 5 761 121 en donne un exemple pour une structure PMOS. Plus précisément, une telle cellule comporte un transistor à grille flottante et une grille de commande qui est réalisée par implantation au sein d'un substrat semiconducteur. Cette couche enterrée, qui fait office de grille de commande, est couplée de façon capacitive à la grille flottante. La grille de commande et le transistor à grille flottante sont électriquement isolés par une zone d'isolation, par exemple du type à tranchées peu profondes (STI : « Shallow Trench Isolation »).

La couche de matériau de grille, en général du polysilicium, au sein de laquelle est réalisée la grille flottante du transistor, est isolée de la zone active par un diélectrique, par exemple du dioxyde de silicium.

Alors que la programmation d'une telle cellule-mémoire s'effectue par injection d'électrons chauds dans la grille flottante du transistor (CHE : « Channel Hot Electrons » en langue anglaise), l'effacement électrique d'une telle cellule-mémoire s'effectue par application d'une tension élevée sur la source, le drain et le substrat du transistor et par application d'une tension beaucoup plus faible sur la grille de commande, ce qui provoque un fort champ électrique inversé et donc une évacuation des électrons stockés dans la grille flottante vers les régions de source, de drain et de canal du transistor, et ce en traversant l'oxyde de grille du transistor.

Or, ce processus d'effacement, lorsqu'il est répété de façon cyclique, comme c'est généralement le cas pour des applications mémoire, provoque une dégradation de l'oxyde de grille du transistor ainsi qu'une dégradation de la tension de seuil de ce transistor.

En d'autres termes, les évacuations répétées des électrons à travers l'oxyde de grille du transistor provoquent à terme un vieillissement de celui-ci.

L'invention vise à apporter une solution à ce problème.

L'invention a pour but de proposer une structure de cellule-mémoire évitant le phénomène de vieillissement du transistor lors des cycles répétés d'effacement.

L'invention a également pour but de permettre une programmation de la cellule, soit par une programmation du type « porteurs chauds », soit par une programmation du type « Fowler-Nordheim ».

L'invention a également pour but de fournir une telle mémoire dont le procédé de fabrication soit totalement compatible avec un procédé classique de fabrication CMOS.

L'invention propose donc un dispositif semiconducteur de mémoire, comprenant une cellule-mémoire non volatile, programmable et effaçable électriquement, à une seule couche de matériau de grille, et comportant un transistor à grille flottante et une grille de commande.

Selon une caractéristique générale de l'invention, les régions de source, de drain et de canal du transistor à grille flottante forment la grille de commande. Par ailleurs, la cellule-mémoire comporte une zone diélectrique disposée entre une première partie de la couche de matériau de grille et une première zone active semiconductrice électriquement isolée d'une deuxième zone active incorporant la grille de commande. Cette zone diélectrique forme alors une zone « tunnel » pour, lors d'un effacement de la cellule, permettre le transfert vers ladite première zone active des charges stockées dans la grille flottante.

La région de canal s'entend ici comme étant la région semiconductrice s'étendant entre la région de source et la région de drain sous la grille du transistor.

La structure de la cellule-mémoire, selon l'invention, est par conséquent totalement différente des structures classiques en ce sens qu'elle ne comporte pas de grille de commande distincte du transistor à grille flottante. En effet, selon l'invention, c'est une partie du transistor à grille flottante, et plus particulièrement les régions de source, de drain et de canal de ce transistor, qui forment la grille de commande.

Par ailleurs, l'évacuation des charges lors d'un effacement de la cellule s'effectue à travers, non plus l'oxyde de grille du transistor à grille flottante, mais à travers un oxyde de grille (matériau diélectrique) qui est situé en regard d'une zone active électriquement isolée de la zone active incorporant la grille de commande, et par conséquent les régions de source, de canal et de drain du transistor à grille flottante. En conséquence, la dégradation de l'oxyde de la zone tunnel selon l'invention, ne provoque pas le vieillissement du transistor de la cellule.

Le fait que les régions de source, drain et canal du transistor forment la grille de commande et que la zone tunnel située en regard de ladite première zone active constitue la zone de transfert de charges, est lié au fait que le couplage capacitif entre la deuxième zone active (celle dans laquelle sont réalisées les régions de source, de drain et de canal du transistor) et la grille flottante, est plus important que le couplage capacitif au niveau de la zone tunnel. Les différents couplages capacitifs dépendent des surfaces de matériau de grille en regard des zones actives ainsi que des différentes tensions appliquées sur les différentes électrodes de la cellule-mémoire. L'homme du métier saura ajuster ces différents paramètres pour obtenir l'effet recherché.

Cependant, pour obtenir les avantages de la cellule-mémoire selon l'invention, tout en appliquant des tensions raisonnables sur les électrodes de la cellule-mémoire, c'est-à-dire des tensions de l'ordre de quelques volts à la dizaine de volts, on choisira avantageusement une valeur capacitive de la zone tunnel inférieure ou égale à 30% de la valeur capacitive totale entre la couche de matériau de grille et l'ensemble des zones actives de la cellule-mémoire.

Selon un mode de réalisation de l'invention, le transistor a une grille annulaire et la couche de matériau de grille comporte, outre la grille annulaire et ladite première partie, une partie de liaison entre cette première partie et la grille annulaire.

Plusieurs possibilités existent pour l'isolement électrique entre la première zone active (celle dans laquelle vont être évacuées les charges lors de l'effacement) et la deuxième zone active (celle dans laquelle est réalisé le transistor).

Selon un premier mode de réalisation, la première zone active et la deuxième zone active peuvent être électriquement isolées l'une par rapport à l'autre en profondeur par des jonctions PN destinées à être polarisées en inverse, et en surface par une région d'isolation, par exemple une région d'isolation du type tranchées peu profondes.

Dans ce cas, et selon un exemple de réalisation, la première zone active est réalisée dans une première région de substrat (par exemple un caisson) ayant un premier type de conductivité, par exemple le type de conductivité N. La deuxième zone active est réalisée dans une deuxième région de substrat (par exemple un caisson) ayant également le premier type de conductivité. La première région de substrat et la deuxième région de substrat sont alors séparées par une troisième région de substrat (par exemple un autre caisson) ayant un deuxième type de conductivité différent du premier, par exemple le type de conductivité P. La région d'isolation s'étend entre la première région de substrat et la deuxième région de substrat et comporte alors un orifice débouchant sur une zone de prise de contact (zone P⁺ par exemple) de la troisième région semiconductrice.

En variante, la première zone active et la deuxième zone active peuvent être électriquement isolées l'une par rapport à l'autre uniquement par des jonctions PN destinées à être polarisées en inverse.

Un tel mode de réalisation permet d'obtenir une meilleure rétention de données. En effet, il a été observé qu'il convenait de choisir une épaisseur du diélectrique supérieure à 60 Å, de façon à obtenir une bonne rétention des données. Or, il a été observé qu'il se produisait un amincissement du diélectrique de grille à l'interface entre la zone d'isolation, par exemple du type tranchées peu profondes, et le matériau de grille. Et, ceci conduit à une moins bonne rétention de données. Par conséquent, le mode de réalisation qui ne prévoit aucun chevauchement de région d'isolation par la couche de matériau de grille résout ce problème.

Plus précisément, selon un mode de réalisation, la couche de matériau de grille s'étend intégralement au-dessus des trois régions de substrat précitées, sans chevaucher de région d'isolation.

Quel que soit le mode de réalisation, la première région de substrat comporte en surface une zone de prise de contact ayant le premier type de conductivité, par exemple une zone de prise de contact de type N⁺ dans un caisson N.

Ceci étant, afin de faciliter l'effacement, il peut s'avérer avantageux de ménager en surface de la première zone active, outre la prise de contact précitée, une zone surfacique ayant le deuxième type de conductivité, par exemple le type P⁺, et s'étendant autour de ladite zone tunnel. Bien entendu, cette zone surfacique est électriquement reliée à la zone de prise de contact, par exemple par une siliciuration.

Ainsi, on réalisera avec la première partie de matériau de grille, un transistor PMOS par exemple, dont les régions de source et de drain sont court-circuitées. Ceci permettra de rendre bien conductrice la partie de zone active située sous la première partie du matériau de grille.

Il serait également possible de ne pas limiter localement la prise de contact, mais de réaliser en surface toute une zone fortement dopée ayant le premier type de conductivité, par exemple le type N⁺. Ceci étant, ceci conduirait probablement à un effacement périmétrique.

Selon un mode de réalisation de l'invention, le dispositif comporte en outre des moyens de polarisation possédant un état de programmation de la cellule-mémoire, un état de lecture de la cellule-mémoire et un état d'effacement de la cellule-mémoire.

Dans l'état d'effacement, les moyens de polarisation provoquent un effacement du type Fowler-Nordheim, en appliquant une tension sur la première zone active beaucoup plus élevée que les tensions appliquées sur les régions de source, de drain et de substrat du transistor.

A cet égard, dans l'état d'effacement, les moyens de polarisation appliquent de préférence des tensions égales sur les régions de source, de drain et de substrat du transistor.

Dans l'état de programmation, les moyens de polarisation peuvent provoquer une programmation par porteurs chauds au niveau du transistor.

Ils peuvent également provoquer une programmation du type Fowler-Nordheim, en appliquant sur les régions de source, de drain et de substrat du transistor, des tensions, de préférence égales, et beaucoup plus élevées que celles appliquées sur la première zone active.

Par ailleurs, dans l'état de lecture, on choisira avantageusement une différence de tension drain/source limitée à 1 volt en valeur absolue. Ceci permet d'éviter une reprogrammation très lente de la cellule-mémoire, ou bien une programmation parasite non-voulue d'une cellule-mémoire vierge.

Le transistor à grille flottante est de préférence un transistor PMOS. Ceci étant, l'invention s'applique également à un transistor du type NMOS.

Le dispositif peut comporter un plan-mémoire comportant plusieurs cellules-mémoires.

Le dispositif peut ainsi former une mémoire du type EEPROM ou du type FLASH.

L'invention a encore pour objet un circuit intégré comportant un dispositif tel que défini ci-avant.

D'autres avantages et caractéristiques de l'invention apparaîtront à l'examen de la description détaillée de modes de réalisation nullement limitatifs, et des dessins annexés, sur lesquels :
- les figures 1, 1a, 1b illustrent schématiquement un premier mode de réalisation d'un dispositif de mémoire, selon l'invention ;
- les figures 2, 2a, 2b illustrent schématiquement un deuxième mode de réalisation d'un dispositif de mémoire, selon l'invention ;
- les figures 3, 3a, 3b illustrent schématiquement un troisième mode de réalisation d'un dispositif de mémoire, selon l'invention ;
- la figure 4 illustre schématiquement des polarisations appliquées sur les électrodes d'un dispositif de mémoire, selon l'invention, en fonction de l'état de ce dispositif,
- la figure 5 illustre schématiquement un quatrième mode de réalisation d'un dispositif de mémoire selon l'invention, particulièrement destiné à être incorporé au sein d'un plan mémoire,
- la figure 6 illustre un mode de réalisation d'un tel plan mémoire,
- les figures 7 et 8 illustrent schématiquement des polarisations appliquées sur les électrodes du dispositif de mémoire des figures 5 et 6, en fonction de l'état de ces dispositifs,
- les figures 9 à 11 illustrent schématiquement une variante de l'invention prévoyant une programmation par porteurs chauds en deux étapes,
- la figure 12 illustre schématiquement un cinquième mode de réalisation d'un dispositif de mémoire selon l'invention, particulièrement destiné à être incorporé au sein d'un plan mémoire,
- les figures 13 et 14 illustrent un mode de réalisation d'un tel plan mémoire, et
- la figure 15 illustre schématiquement des polarisations appliquées sur les électrodes du dispositif de mémoire des figures 12 et 13, en fonction de l'état de ces dispositifs.

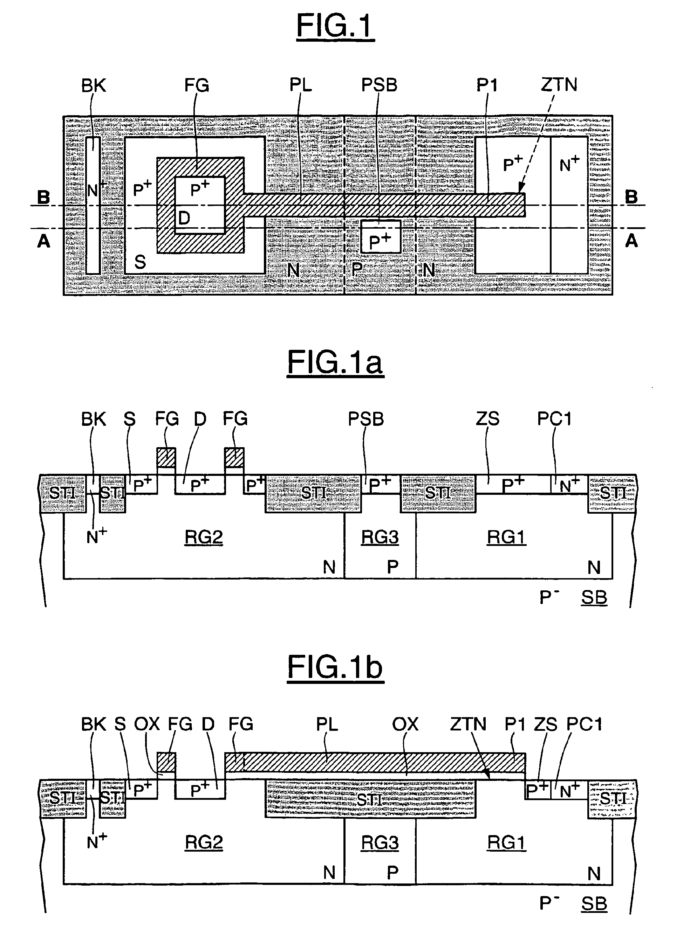

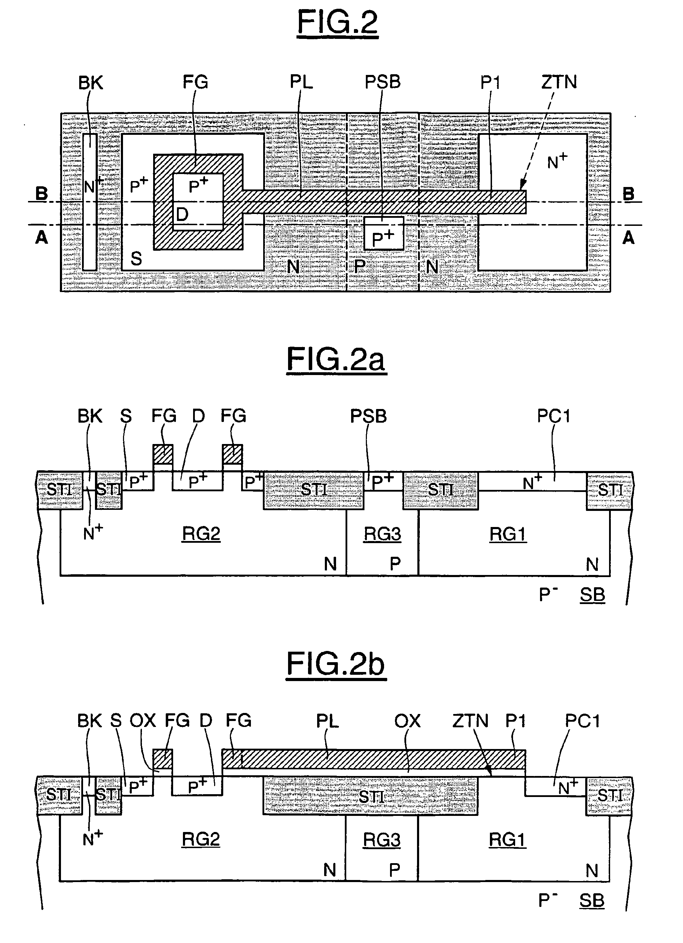

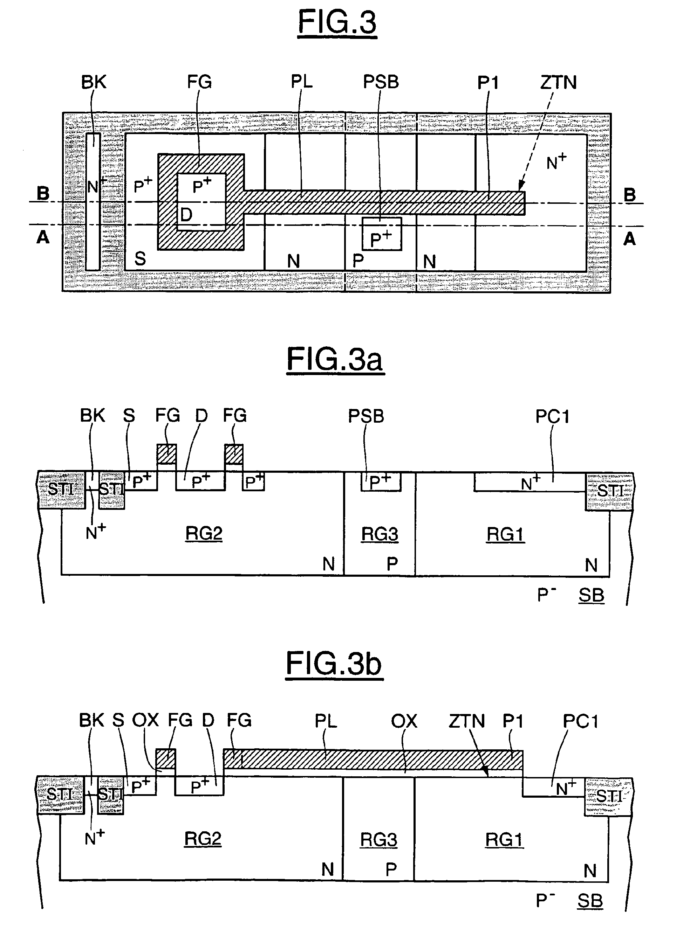

Dans la suite, les figures 1a (respectivement 2a et 3a) et 1b (respectivement 2b, et 3b) sont respectivement des sections selon les lignes A-A et B-B de la figure 1 (respectivement de la figure 2 et de la figure 3).

Sur les figures 1a et 1b, la référence SB désigne un substrat semiconducteur, par exemple en silicium dopé P⁻, d'un circuit intégré.

Ce substrat SB comporte une première région de substrat RG1 formée d'un caisson semiconducteur dopé N, ainsi qu'une deuxième région de substrat RG2 formée d'un autre caisson semiconducteur dopé N. Les deux caissons RG1 et RG2 sont séparés par une troisième région semiconductrice RG3 formée d'un caisson dopé P.

Le caisson RG3 assure l'isolation électrique mutuelle en profondeur des deux caissons RG1 et RG2. En effet, cette isolation électrique est réalisée par des jonctions PN qui seront polarisées en inverse.

En surface, l'isolation électrique mutuelle des deux caissons RG1 et RG2 est assurée par une région d'isolation STI, par exemple du type tranchées peu profondes.

La région d'isolation STI comporte un orifice débouchant sur une zone de prise de contact PSB, dopée P⁺, et située en surface du caisson RG3. Cette prise de contact PSB va permettre d'assurer une polarisation du caisson RG3 et également du substrat sous-jacent SB.

Le caisson RG1 forme une première zone active, tandis que le caisson RG2 forme une deuxième zone active.

Au-dessus de ces deux zones actives, est prévue une couche d'un matériau de grille, par exemple du polysilicium, reposant sur la surface des deux zones actives par l'intermédiaire d'un oxyde de grille OX, par exemple du dioxyde de silicium.

La couche de matériau de grille, qui forme dans son ensemble une grille flottante, comporte une première partie P1 surplombant la première zone active RG1.

La couche de matériau de grille comporte également une partie FG annulaire disposée au-dessus de la deuxième zone active RG2. Cette partie annulaire de matériau de grille définit la grille FG d'un transistor PMOS, également appelée transistor de stockage des charges ou de lecture, dont la source S, formée d'une région implantée de type P⁺, se situe dans le caisson RG2 à l'extérieur de la grille annulaire, et dont le drain D formé également d'une région implantée de type P⁺, se situe dans le caisson RG2 à l'intérieur de l'anneau formant la grille FG.

La couche de matériau de grille comporte également une partie de liaison PL reliant la partie annulaire FG et la première partie P1.

La géométrie de la première partie P1 a été choisie de façon à ce que la valeur capacitive de la zone d'oxyde OX située sous cette première partie P1, et également appelée zone tunnel ZTN pour des raisons qui seront explicitées plus en détail ci-après, soit inférieure ou égale à 30% de la valeur capacitive totale entre la couche de matériau de grille et l'ensemble des zones actives de la cellule-mémoire, c'est-à-dire la somme des capacités formées entre le matériau de grille et chacune des zones actives de la cellule-mémoire.

De ce fait, les régions de source, de drain et de canal, qui sont couplées de façon capacitive à la grille FG, vont former une grille de commande pour cette cellule-mémoire, tandis que la zone tunnel ZTN va former une zone de transfert des charges permettant l'évacuation, lors d'un effacement de la cellule-mémoire, des charges stockées dans la grille flottante vers la première zone active RG1.

En ce qui concerne la grille de commande, c'est bien entendu la zone de canal qui participe essentiellement au couplage capacitif avec la grille annulaire FG. Ceci étant, l'homme du métier sait que les régions de source et de drain débordent également par diffusion sous la grille annulaire FG. Aussi, ces régions de source et de drain participent-elles également en pratique à ce couplage capacitif.

Afin de polariser de façon adéquate la première zone active RG1, celle-ci comporte une zone implantée N⁺, référencée PC1, et permettant une prise de contact.

Par ailleurs, dans ce mode de réalisation, il est également prévu une zone surfacique ZS, dopée P⁺, et s'étendant autour de la zone tunnel ZTN.

L'homme du métier aura noté que l'on a ainsi formé avec la première partie P1 de la couche de matériau de grille, un transistor PMOS court-circuité, c'est-à-dire dont les régions de source et de drain, dopées P⁺, sont reliées électriquement.

Cette zone surfacique ZS est électriquement reliée à la zone de prise de contact PC1, par exemple par une siliciuration surfacique.

En ce qui concerne la deuxième zone active RG2, il est également prévu une région implantée N⁺, référencée BK, permettant une prise de contact et une polarisation de ce caisson RG2, et par conséquent une polarisation du substrat du transistor de lecture.

Le procédé de fabrication d'une telle cellule-mémoire comporte, tout d'abord, la réalisation connue en soi dans le substrat SB de type P⁻ des régions d'isolation latérales STI.

Puis, on procède de façon connue en soi, à l'implantation des caissons RG1, RG2 et RG3.

Puis, après avoir réalisé sur la surface de la structure ainsi obtenue une couche d'oxyde OX, on dépose une couche de matériau de grille, par exemple du polysilicium, que l'on grave de façon à former dans cette couche la grille annulaire FG, la partie de liaison PL et la première partie P1. On procède ensuite à la réalisation des différentes régions implantées P⁺ et N⁺, la couche de matériau de grille servant alors notamment de masque dur.

On procède ensuite à une siliciuration classique des régions de source, de drain et des prises de contact PC1, BK, ainsi que de la zone surfacique ZS.

On termine ensuite le procédé de fabrication par des prises de contact classiques sur les régions de source, de drain, sur la région BK et sur la prise de contact PC1.

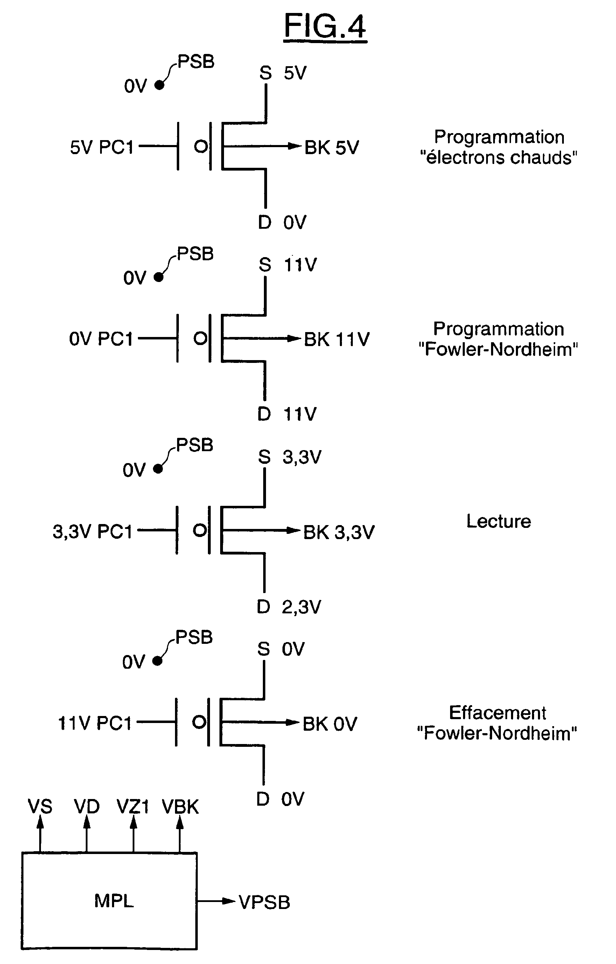

On va maintenant décrire, en se référant plus particulièrement à la figure 4, le fonctionnement de la cellule-mémoire selon l'invention.

A cet égard, le dispositif de mémoire selon l'invention, comporte des moyens de polarisation MPL, par exemple des sources de tension associées à une logique de commande, ces moyens de polarisation possédant un état de programmation de la cellule-mémoire, un état de lecture de cette cellule-mémoire et un état d'effacement de cette cellule-mémoire.

Dans chacun de ces états, les moyens MPL délivrent sur la source S, le drain D et le substrat BK du transistor, des tensions VS, VD et VBK. Ils polarisent également le substrat RG3 avec une tension VPSB appliquée sur la zone de contact PSB, et la première zone active RG1 avec une tension VZ1 appliquée sur la zone de contact PC1.

Une première possibilité pour programmer électriquement la cellule-mémoire, consiste à adopter une programmation dite « par électrons chauds ». Plus précisément, lorsqu'on veut programmer électriquement la cellule-mémoire, c'est-à-dire lorsqu'on veut stocker des charges dans la grille flottante, on applique par exemple sur la source du transistor une tension égale à 5 volts et sur le drain une tension égale à 0 volt.

On polarise par ailleurs le substrat du transistor à 5 volts et on applique sur la prise de contact PC1 de la première zone active une tension qui peut varier en pratique entre 0 et 5 volts, par exemple 5 volts. On polarise par ailleurs le substrat (prise de contact PSB) à 0 volt. Le transistor est alors passant (sous réserve d'une tension grille/source suffisante pour initialiser la conduction du transistor), ce qui crée une saturation de ce transistor et provoque un courant de trous provenant de la source. Ces trous entrent en collision avec le réseau cristallin et forment des trous chauds et des électrons chauds. Les électrons chauds sont attirés dans la grille flottante dont le potentiel chute légèrement par rapport à celui appliqué sur la source.

Une autre possibilité de programmation de la cellule-mémoire, selon l'invention, consiste à effectuer une programmation du type Fowler-Nordheim, c'est-à-dire appliquer un champ électrique important pour abaisser les barrières énergétiques et permettre le transit des électrons vers la grille flottante.

Plus précisément, dans ce cas, on appliquera par exemple sur la source, le drain et le substrat du transistor, des tensions égales dont la valeur est relativement élevée, par exemple comprise entre 8 et 11 volts, et typiquement 11 volts. Parallèlement, alors que le caisson RG3 est toujours polarisé à 0 volt, on applique une tension égale à 0 volt sur la prise de contact PC1 de la première zone active.

De ce fait, la grille flottante est portée à un potentiel sensiblement égal à 10 volts, tandis que la première zone active est à 0 volt. Il se crée donc un fort champ électrique qui va attirer les électrons de la première zone active RG1 vers la grille flottante à travers l'oxyde de la zone tunnel ZTN.

La cellule-mémoire, selon l'invention, présente donc l'avantage de pouvoir être programmée de deux façons différentes, soit par une programmation du type électrons chauds, soit par une programmation du type Fowler-Nordheim. Il sera ainsi possible de choisir le type de programmation en fonction des applications envisagées.

En effet, une programmation par électrons chauds est plus consommatrice de courant, mais est par contre plus rapide qu'une programmation du type Fowler-Nordheim, qui présente une consommation moindre. On choisira donc, de préférence, une programmation du type Fowler-Nordheim dans des applications de téléphonie mobile.

Dans l'état de lecture, on limite volontairement la différence de tension drain/source à -1 volt de façon à éviter une reprogrammation très lente de la cellule-mémoire. On choisira ainsi par exemple une tension sur la source de 3,3 volts, et une tension sur le drain de 2,3 volts. Le substrat BK sera polarisé à 3,3 volts et la grille de commande (source et drain) pourra être polarisée avec une tension variant entre 0 et 3,3 volts.

Ainsi, si lors de la programmation, on a programmé un zéro dans la cellule-mémoire, c'est-à-dire si l'on n'a en fait effectué aucune programmation, le transistor sera bloqué lors de la lecture.

Si, par contre, lors de l'état de programmation, on a programmé un « 1 » (par exemple) dans la cellule-mémoire, c'est-à-dire si l'on a stocké des charges dans la grille flottante, le transistor conduira lors de la lecture. Ainsi, la détection ou non d'un courant dans l'état de lecture permet de déterminer la valeur logique qui a été écrite ou programmée dans la cellule.

Pour procéder à l'effacement de la cellule-mémoire, on applique une tension sur la première zone active beaucoup plus élevée que celles appliquées sur les régions de source, de drain et de substrat du transistor.

A titre indicatif, on applique une tension nulle sur la source, le substrat et le drain du transistor, et une tension par exemple égale à 11 volts sur la prise de contact PC1, le substrat RG3 étant toujours polarisé à 0 volt. Cet effacement, du type Fowler-Nordheim, conduit donc à l'application d'un champ électrique très élevée, inverse de celui de la programmation, et provoque par conséquent l'évacuation des charges stockées dans la grille flottante vers la zone active RG1 jusqu'à la prise de contact PC1, via la zone tunnel ZTN.

Il n'y a donc pas de dégradation de l'oxyde du transistor de la cellule-mémoire qui correspond à la zone de plus fort couplage.

Dans certains cas, l'effacement d'une cellule-mémoire peut conduire cette cellule dans un état de sur-effacement, par exemple lorsque la durée d'effacement est trop longue.

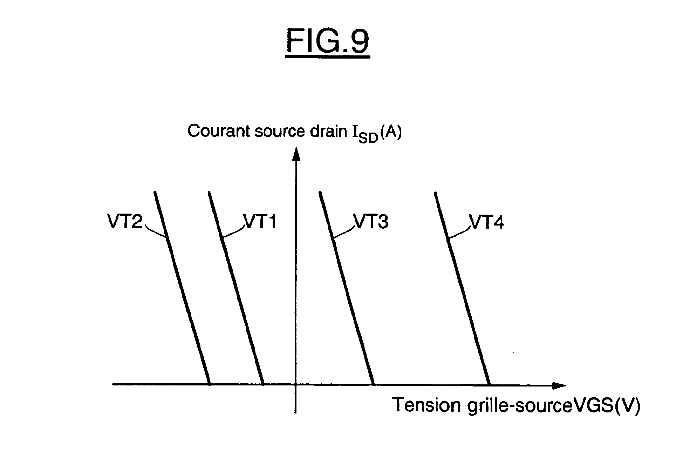

Cet état de sur-effacement se traduit lorsque le transistor de la cellule est un transistor PMOS, par la présence de charges électriques positives dans la grille flottante du transistor. En terme de tension de seuil VT, cet état est illustré sur la figure 9.

Sur cette figure la courbe VT1 correspond à une tension de seuil d'un transistor PMOS d'une cellule sortie de fabrication. Typiquement la tension de seuil est de l'ordre de -0,6 Volt.

Lorsqu'une cellule est programmée par électrons chauds, des électrons sont stockés dans la grille flottante, ce qui provoque un décalage de la tension de seuil vers les valeurs positives, par exemple vers une valeur de l'ordre de 1,4 Volts (courbe VT4). Le décalage de tension de seuil est alors de l'ordre de 2 volts.

L'effacement de cette cellule programmée vise à ramener la tension de seuil du transistor sensiblement à sa valeur initiale (courbe VT1).

Mais en cas de sur-effacement, cela se traduit par un décalage de la tension de seuil vers les valeurs négatives (par exemple courbe VT2). Et dans ce cas une reprogrammation de la cellule peut s'avérer extrêmement difficile, voire impossible. En effet si la valeur absolue de la tension de seuil du transistor reste supérieure à la valeur absolue de la différence de tension grille-source, le transistor de la cellule ne peut pas entrer en conduction, empêchant alors la production des électrons chauds.

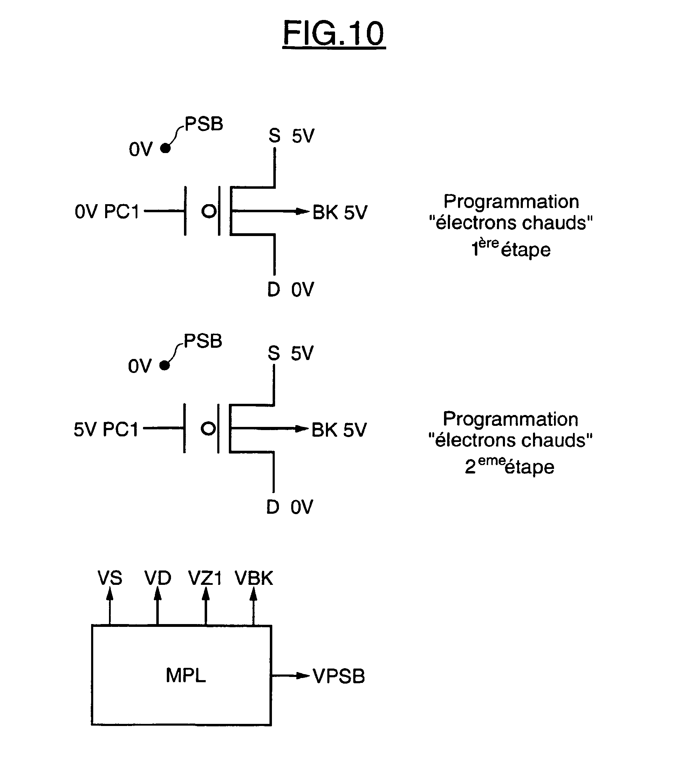

Afin de remédier à cet inconvénient, les moyens de polarisation MPL vont programmer une cellule-mémoire ayant subi un effacement et dont le transistor est un transistor PMOS, en provoquant une programmation par électrons chauds au niveau du transistor en deux étapes successives, de façon à d'abord compenser les éventuelles charges positives résiduelles présentes dans la grille flottante puis à effectuer une programmation optimale (figure 10).

Plus précisément, dans la première étape, les moyens de polarisation MPL compensent les éventuelles charges positives résiduelles présentes dans la grille flottante en appliquant une tension de compensation VZ1 sur le contact PC1 de la première zone active.

Cette tension VZ1 est par exemple égale à 0 volt, mais elle pourrait être également négative, par exemple supérieure à -500 mV environ. Il convient cependant de veiller à ne pas appliquer une tension de compensation trop négative afin de ne pas mettre en conduction directe la diode PN formée par le caisson RG1 et le caisson RG3.

L'application de cette tension de compensation, par exemple pendant 500 microsecondes, permet non seulement de compenser le décalage négatif de la tension de seuil, mais également d'initier la programmation par électrons chauds. Ainsi à la fin de cette première étape, la tension de seuil se retrouve décalée vers la droite par rapport à la tension initiale (courbe VT3 décalée vers la droite par rapport à la courbe VT1).

La programmation optimale s'effectue en appliquant ensuite, par exemple pendant 100 microsecondes, une tension VZ1 sur le contact PC1 égale à 5 volts. La tension de seuil est alors à nouveau décalée à droite (courbe VT4).

On aura donc noté que cette variante de l'invention permet de s'affranchir de l'inconvénient lié au sur-effacement en employant une programmation en deux étapes utilisant le contact PC1 qui est habituellement utilisé pour l'effacement.

L'invention n'est pas limitée au mode de réalisation qui vient d'être décrit, mais en embrasse toutes les variantes.

Ainsi, comme illustré sur les figures 2, 2a et 2b, la prise de contact PC1, dopée N⁺' de la première zone active, peut s'étendre sur toute la surface de cette première zone active, sauf bien entendu sous la première partie P1 du matériau de grille

Ceci étant, puisqu'il n'y a pas d'implantation dans la partie de liaison PL du matériau de grille, il se forme alors, dans le matériau de grille, une diode PIN, c'est-à-dire une diode formée d'une région P⁺, et d'une région N⁺ séparée par une région de matériau de grille intrinsèque. Or, lors de l'effacement, cette diode est polarisée en inverse et peut contrecarrer quelque peu l'efficacité d'effacement. C'est la raison pour laquelle, dans certaines applications, on préférera utiliser le mode de réalisation illustré sur les figures 1, la et 1b.

Dans un autre mode de réalisation, la prise de contact PC1 peut rester localisée et le reste de la zone active RO1 dopée N.

Un autre mode de réalisation envisageable est celui illustré sur les figures 3, 3a et 3b. On remarque, sur ces figures, l'absence en surface de zones d'isolation STI entre la première zone active et la deuxième zone active. L'isolation est réalisée ici uniquement par des jonctions PN polarisées en inverse.

Dans l'exemple décrit sur ces figures 3, la première zone active est implantée en surface du type N⁺. Cependant, la prise de contact N⁺ pourrait être localisée et l'on pourrait également avoir une implantation P⁺ du type zone surfacique analogue à celle illustrée sur les figures 1.

Ce mode de réalisation, dans lequel la couche de matériau de grille s'étend intégralement au-dessus des zones actives de la cellule-mémoire sans chevaucher de région d'isolation latérale, permet une meilleure rétention des données. En effet, on évite ainsi le phénomène d'amincissement d'oxyde à l'interface entre une zone d'isolation et le matériau de grille.

Il conviendra toutefois dans ce mode de réalisation d'utiliser un masque approprié lors de l'étape de siliciuration afin de ne pas siliciurer la grille flottante ni les fonctions PN en surface, et donc de ne pas créer de court-circuit métallique. En outre, le fait de ne pas siliciurer la grille flottante permet une meilleure rétention des données.

Bien entendu, la programmation, la lecture et l'effacement de cellules-mémoires telles que celles illustrées sur les figures 2 et sur les figures 3, sont analogues à celles décrites en référence aux figures 1.

Enfin, bien que la cellule-mémoire non volatile programmable et effaçable électriquement qui vient d'être décrite utilise un transistor PMOS, une réalisation à base d'un transistor NMOS est également envisageable.

Par ailleurs, on peut prévoir plusieurs cellules-mémoires, de façon à former un plan-mémoire qui peut être effaçable bit par bit de façon à former une mémoire du type EEPROM, ou bien effaçable par banc ou par page de façon à former une mémoire du type FLASH. Cependant, il conviendra alors d'associer un transistor d'accès à chaque cellule-mémoire de façon à pouvoir la sélectionner.

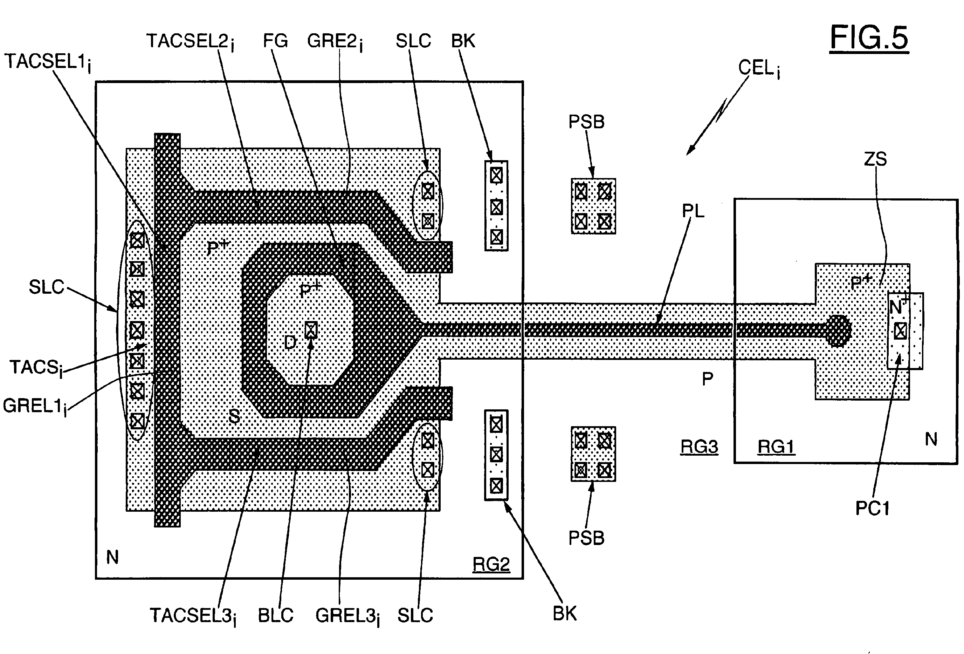

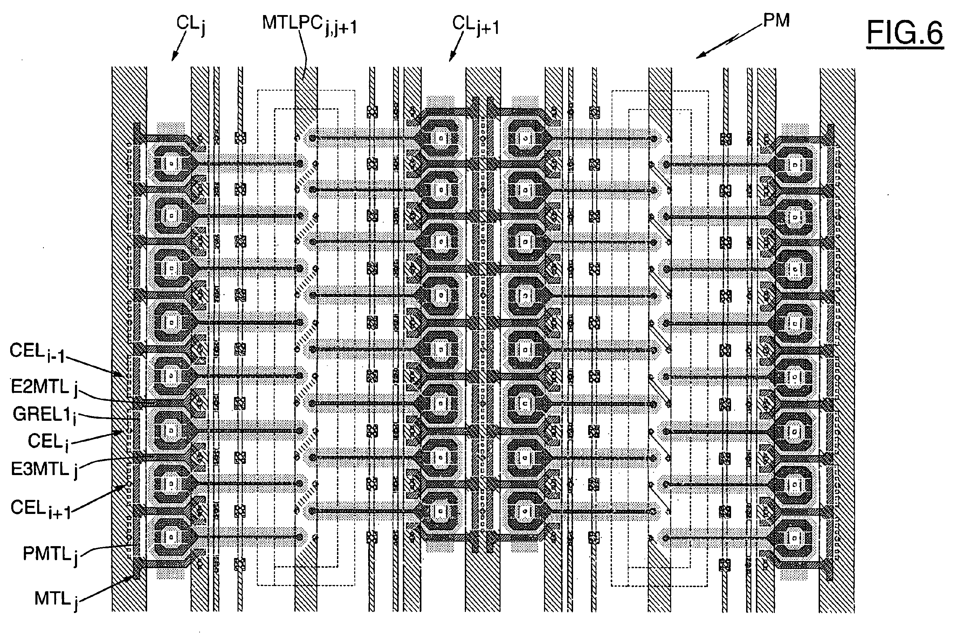

A cet égard, le mode de réalisation de la cellule illustrée sur la figure 5 va permettre de réaliser un plan mémoire tel que celui illustré sur la figure 6, offrant une architecture de taille réduite avec un fort courant de programmation des cellules et une bonne isolation entre les lignes de bits.

Ceci est obtenu selon l'invention, notamment par l'utilisation d'un transistor d'accès ayant une forme particulière qui va conduire à mettre à contribution les transistors d'accès des cellules voisines.

Plus précisément, comme illustré sur la figure 5, on voit qu'une cellule-mémoire CELᵢ que l'on suppose ici être encadrée par deux cellules-mémoires adjacentes CELᵢ₋₁ et CELᵢ₊₁ situées dans une même colonne CLⱼ que ladite cellule-mémoire (figure 6), comporte un transistor d'accès référencé TACSᵢ.

Ce transistor d'accès TACSᵢ, affecté à la cellule-mémoire CELᵢ, entoure partiellement le transistor à grille flottante FG de la cellule-mémoire.

Plus précisément, ce transistor d'accès TACSᵢ peut être décomposé en trois transistors d'accès élémentaires.

Ainsi, un premier transistor d'accès élémentaire TACSEL1ᵢ est spécifiquement associé à la cellule-mémoire CELᵢ.

Par contre, le deuxième transistor d'accès élémentaire TACSEL2ᵢ et le troisième transistor d'accès élémentaire TACSEL3ᵢ sont respectivement communs aux deux transistors d'accès TACSᵢ₋₁ et TACSᵢ₊₁ respectivement affectés aux deux cellules-mémoires adjacentes CELᵢ₋₁ et CEL_{i-1.}

La source du transistor d'accès TACSᵢ forme la source du premier transistor d'accès élémentaire TACSEL1ᵢ.

Par ailleurs, le drain du premier transistor d'accès élémentaire TACSEL1ᵢ forme une partie de la source S du transistor à grille flottante FG de la cellule-mémoire.

Si l'on se réfère maintenant plus particulièrement à la figure 6 qui représente le plan mémoire formé des cellules illustrées sur la figure 5, on voit que chaque colonne de cellule-mémoire, par exemple la colonne CLⱼ comporte une couche de matériau de grille MTLⱼ possédant une partie principale PMTL s'étendant dans le sens de la colonne le long et en vis-à-vis de tous les transistors à grille flottante FG des cellules.

La grille GREL1ᵢ du premier transistor élémentaire TACSEL1ᵢ du transistor d'accès TACSᵢ comporte alors la portion de ladite partie principale de la couche de matériau de grille MTLⱼ située en vis-à-vis du transistor à grille flottante FG de la cellule CELᵢ.

Par ailleurs, cette couche de matériau de grille MTLⱼ comporte, au niveau de chaque cellule-mémoire, par exemple au niveau de la cellule-mémoire CELᵢ, une deuxième portion élémentaire E2MTLⱼ raccordée à la partie principale PMTLⱼ et s'étendant sensiblement perpendiculairement à cette partie principale d'un côté du transistor à grille flottante.

Cette deuxième portion élémentaire E2MTLⱼ forme alors une partie de la grille GREL2ᵢ du deuxième transistor élémentaire TACSEL2ᵢ.

La couche de matériau de grille MTLⱼ comporte également une troisième portion élémentaire E3MTLⱼ également raccordée à la partie principale PMTLⱼ et s'étendant sensiblement perpendiculairement à cette partie principale de l'autre côté du transistor à grille flottante de la cellule CELᵢ.

Cette troisième portion élémentaire E3MTLⱼ forme une partie de la grille GREL3ᵢ du troisième transistor élémentaire TACSEL3ᵢ.

On remarque par ailleurs sur la figure 6 que la deuxième portion élémentaire E2MTLⱼ associée à une cellule-mémoire forme la troisième portion élémentaire associée à l'une des deux cellules-mémoires adjacentes, tandis que la troisième portion élémentaire E3MTLⱼ associée à la cellule-mémoire CELᵢ forme la deuxième portion élémentaire associée à l'autre des cellules-mémoires adjacentes.

La source de chaque transistor d'accès TACSᵢ comporte une pluralité de contacts SLC qui sont tous reliés ensemble au moyen d'une même métallisation.

De façon à augmenter encore le courant du transistor d'accès lorsque celui-ci est passant, on dispose également d'autres contacts SLC au voisinage externe des extrémités des grilles GREL2ᵢ et GREL3ᵢ des deux autres transistors d'accès élémentaires.

Par ailleurs, les contacts de drain BLC des cellules-mémoires d'une même ligne sont reliés ensemble et forment par conséquent une ligne de bit.

La couche de matériau de grille MTLⱼ de chaque colonne, est également destinée à être polarisée par une tension de polarisation de grille, et la métallisation destinée à véhiculer la tension de polarisation de grille sur la couche MTLⱼ forme une métallisation de colonne ("row line").

On remarque donc ici qu'il n'y a pas de contact spécifique sur la source S du transistor à grille flottante d'une cellule-mémoire. Cette source est par conséquent flottante.

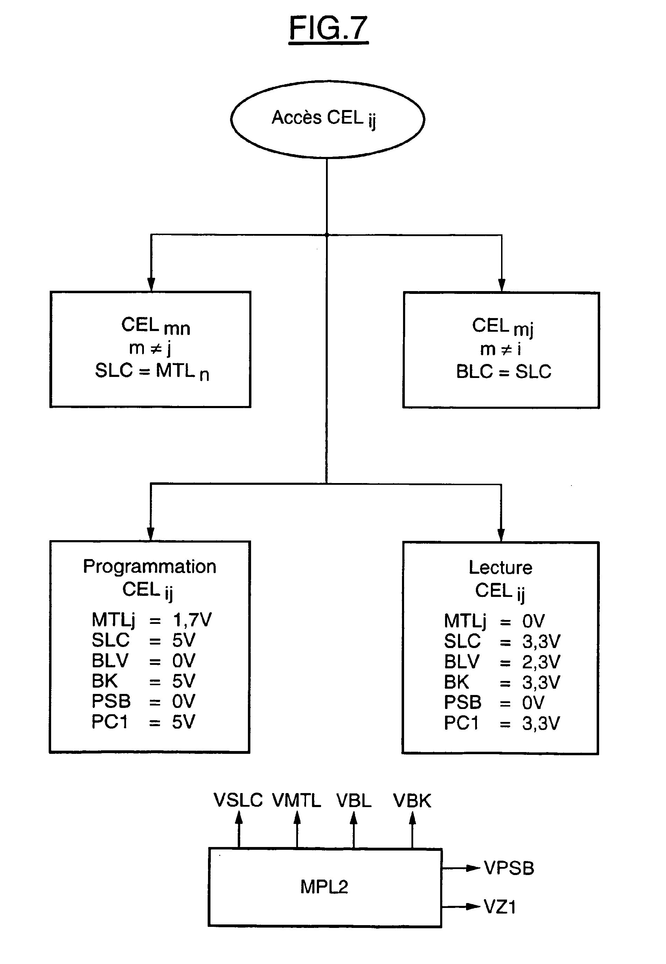

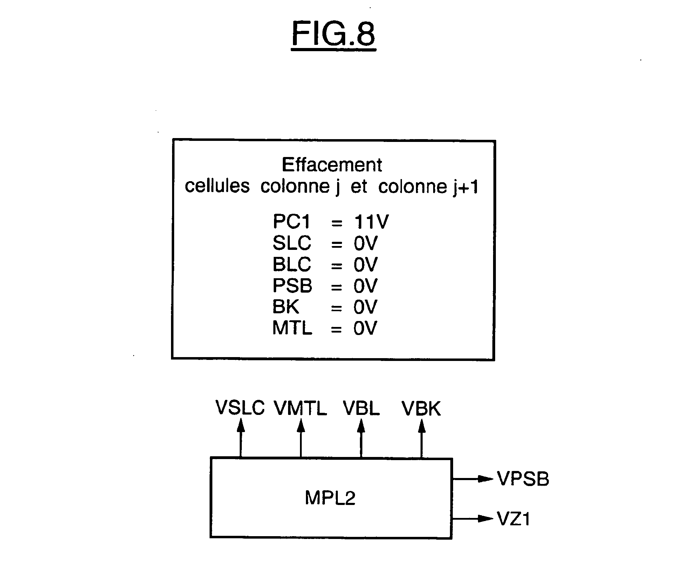

On va maintenant décrire plus particulièrement le fonctionnement du plan mémoire en se référant également aux figures 7 et 8.

D'une façon générale, le dispositif de mémoire selon l'invention comporte des moyens de polarisation MPL2 aptes à sélectionner au moins une cellule-mémoire en programmation et en lecture, et aptes à effacer le plan mémoire par blocs de cellules, en l'espèce ici par deux colonnes simultanément.

En effet, on remarque sur la figure 6 que toutes les prises de contact PC1 des cellules-mémoires de deux colonnes adjacentes CLⱼ et CLⱼ₊₁ sont reliées ensemble par une même métallisation MTLPC_{j,j+1}.

Par contre, en programmation ou en lecture, on pourra si nécessaire ne sélectionner qu'une seule cellule à la fois en jouant sur les polarisations des lignes de bits et des métallisations de colonnes ("row lines").

Il ressort de l'architecture illustrée sur la figure 6 que les moyens de polarisation sont par conséquent aptes à appliquer une même tension de polarisation de source sur les sources respectives SLC des transistors d'accès affectées respectivement aux cellules-mémoires d'une même colonne.

Par ailleurs, ces moyens de polarisation MPL2 peuvent appliquer une même tension de polarisation de grille sur les grilles respectives des transistors d'accès affectées respectivement aux cellules-mémoires d'une même colonne.

Enfin, comme indiqué précédemment, les moyens de polarisation peuvent appliquer une même tension d'effacement sur les premières zones actives respectives RG1 des cellules-mémoires d'au moins une même colonne, et ici en particulier de deux colonnes adjacentes.

D'une façon analogue à ce qui a été décrit pour les modes de réalisation illustrés sur les figures 1 à 3, les moyens de polarisation MPL2 possèdent un état de programmation dans lequel ils sont aptes à programmer une cellule-mémoire. Ils possèdent également un état de lecture dans lequel ils sont aptes à lire une cellule-mémoire. Et ils possèdent un état d'effacement dans lequel ils sont aptes à effacer au moins une colonne de cellules-mémoires.

Dans chacun de ces états, les moyens de polarisation sont aptes à appliquer des tensions prédéterminées sur les sources et les grilles des transistors d'accès, ainsi que sur les drains et les substrats des transistors à grille flottante des cellules, ainsi que sur les premières zones actives RG1.

Considérons maintenant le cas où l'on souhaite accéder à la cellule CELᵢⱼ, cette cellule appartenant à la ligne i et à la colonne j (figure 7).

D'une façon générale, pour accéder à une cellule-mémoire en lecture ou en programmation, les moyens de polarisation MPL2 rendent passants les transistors d'accès des cellules-mémoires appartenant à la même colonne que celle de la cellule-mémoire considérée.

Par ailleurs, les moyens de polarisation appliquent une tension identique sur la source du transistor d'accès et le drain du transistor à grille flottante de chaque cellule-mémoire de ladite colonne, différente de la cellule-mémoire considérée, de façon à ce que les autres cellules-mémoires de la colonne ne soient pas sollicitées.

Enfin, les moyens de polarisation MPL2 rendent bloqués les transistors d'accès des cellules-mémoires appartenant à une autre colonne que celle de la cellule-mémoire considérée.

A titre d'exemple, comme illustré sur la figure 7, pour programmer la cellule CELᵢⱼ, les moyens de polarisation MPL2 appliquent par exemple une tension VMTL = 1,7 volts sur la couche de matériau de grille MTLⱼ de la colonne CLⱼ.

Par ailleurs, ils appliquent une tension VLC égale par exemple à 5 volts, sur tous les contacts de source SLC. En conséquence, la différence de tension grille/source de tous les transistors d'accès de toutes les cellules de la colonne CLⱼ est égale à - 3,3 volts, ce qui rend par conséquent tous ces transistors d'accès passants.

Les moyens de polarisation MPL2 appliquent alors une tension VBL égale à 0 volt sur le contact BLC (ligne de bit) et ils appliquent des tensions VBK, VPSB et VZ1 respectivement égales à 5 volts, 0 volt et 5 volts sur respectivement les contacts BK, PSB et PC1.

La cellule est alors programmée par électrons chauds.

A cet égard, il convient de noter ici que l'invention est remarquable en ce sens que puisque la couche de matériau de grille MTLⱼ forme une équipotentielle, tous les transistors d'accès, c'est-à-dire tous les transistors d'accès élémentaires sont passants, et contribuent à fournir le courant de programmation à la cellule considérée. Bien entendu, la contribution majoritaire est fournie par le transistor d'accès de la cellule et la contribution d'un transistor d'accès est d'autant plus faible que ce transistor d'accès est éloigné de la cellule-mémoire à laquelle on accède.

Bien entendu, puisque l'on ne souhaite accéder qu'à une seule cellule de cette colonne et que tous les transistors d'accès des cellules de cette colonne sont passants, il convient alors, afin de ne pas solliciter les autres cellules CELₘⱼ (m différent de i) de la même colonne, d'appliquer des tensions égales sur les contacts BLC et SLC de ces cellules-mémoires. En d'autres termes, puisque dans le cas présent, la tension VSLC est fixée à 5 volts, on appliquera sur les drains (ligne de bit) des autres cellules de la colonne, une tension de 5 volts.

En ce qui concerne les cellules CELₘₙ (n différent de j), c'est-à-dire les cellules appartenant aux autres colonnes que la colonne comportant la cellule à laquelle on accède, les moyens de polarisation MPL2 appliquent sur les grilles des transistors d'accès MTLₙ une tension VMTL égale à la tension VSLC. Ainsi, tous les transistors d'accès des cellules de ces autres colonnes sont bloqués puisque la différence de tension grille/source est nulle.

Il convient de noter ici que l'on a ainsi réalisé une très bonne isolation entre deux lignes de bits voisines.

Si l'on souhaite maintenant accéder à la cellule CELᵢⱼ en lecture, les moyens de polarisation MPL2 appliquent une tension égale à 0 volt sur les grilles des transistors d'accès et une tension égale à 3,3 volts sur les sources des transistors d'accès, de façon à rendre les transistors d'accès des cellules de la colonne passants.

Dans cet état de lecture, on limite volontairement la différence de tension drain/source du transistor à grille flottante à - 1 volt de façon à éviter une reprogrammation très lente de la cellule-mémoire. On choisira alors une tension sur le drain égale à 2,3 volts. Le substrat BK sera polarisé à 3,3 volts. On appliquera également par exemple la masse sur la prise de contact PSB et 3,3 volts sur la prise de contact PC1.

L'effacement des cellules de deux colonnes voisines est du type Fowler-Nordheim. Plus précisément, dans cet état d'effacement, les moyens de polarisation provoquent un effacement du type Fowler-Nordheim en appliquant une tension sur les premières zones actives RG1 beaucoup plus élevée que celle appliquée sur les régions de source des transistors d'accès et sur les régions de drain et de substrat des transistors à grille flottante.

Ainsi, à titre indicatif, comme illustré sur la figure 8, les moyens de polarisation MPL2 pourront appliquer une tension VZ1 sur la prise de contact PC1 égale à 11 volts tandis que la masse sera appliquée sur toutes les autres prises de contact.

Il convient de noter ici que le fait que la source du transistor à grille flottante de la cellule-mémoire soit elle-même flottante, est compatible avec un effacement du type Fowler-Nordheim via la première zone active RG1. En effet, la source flottante du transistor est tirée à la masse par le point-mémoire lui-même.

Bien entendu, dans la variante illustrée sur les figures 5 et 6, on pourra utiliser une isolation du type de celle illustrée sur les figures 1, 2 et 3 pour isoler mutuellement les différentes régions actives RG1, RG2 et RG3 du point-mémoire.

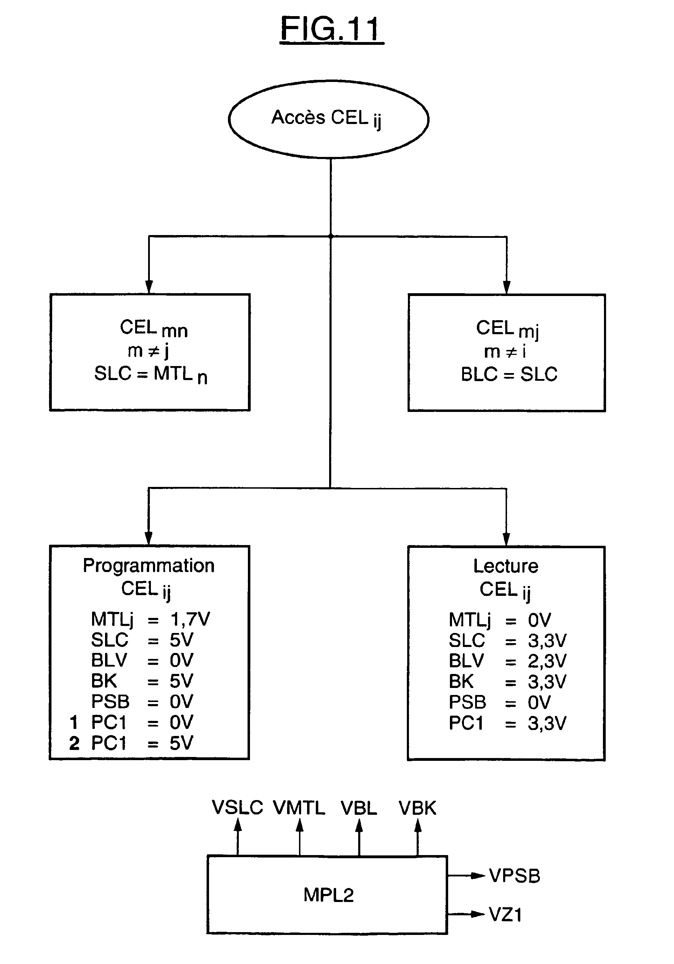

Par ailleurs, une programmation des cellules par électrons chauds en deux étapes, telle qu'elle a été décrite en référence aux figures 1, 2, 3, 9 et 10 peut également s'appliquer au plan mémoire de la figure 6. Plus précisément, comme illustré sur la figure 11, les moyens de polarisation MPL2 appliqueraient alors dans ce cas pour la programmation de la cellule CELᵢⱼ, d'abord une tension VZ1 nulle sur le contact PC1 par l'intermédiaire de la métallisation MTLPC_{i,j+1} (figure 6), puis une tension VZ1 optimale de 5 volts.

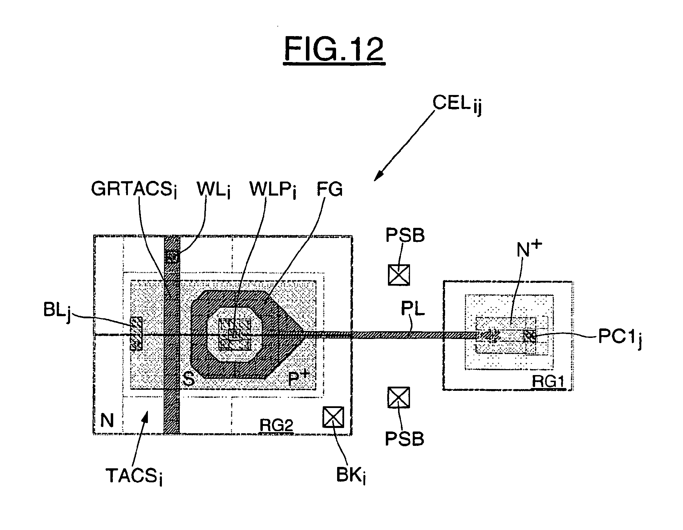

On se réfère maintenant plus particulièrement aux figures 12 et suivantes pour décrire un cinquième mode de réalisation d'une cellule-mémoire selon l'invention, permettant la réalisation d'un plan mémoire nécessitant une consommation réduite pour la phase de programmation, ce qui le rend particulièrement intéressant pour des applications de téléphonie mobile par exemple.

Sur la figure 12, le transistor d'accès TACSᵢ affecté à une cellule-mémoire CELᵢⱼ comporte une grille GRTACSᵢ s'étendant perpendiculairement à ladite partie de liaison PL et à l'opposé de cette partie de liaison par rapport à la grille annulaire FG.

La source du transistor d'accès comporte un contact de source BLⱼ. Le drain du transistor d'accès forme une partie de la source S du transistor à grille flottante de la cellule-mémoire.

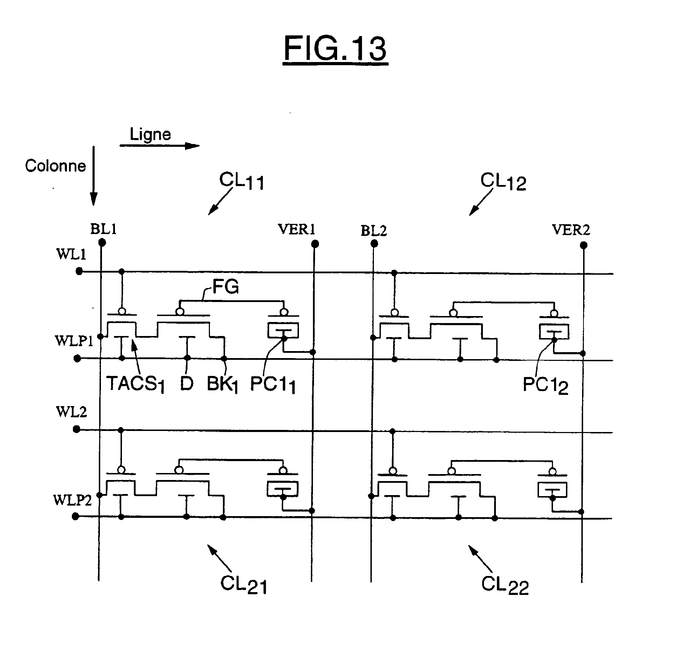

Le drain du transistor à grille flottante est électriquement relié à la deuxième zone active RG2, c'est à dire à son substrat (bulk). En effet la zone de drain comporte un contact WLPᵢ relié par une métallisation, non représentée sur la figure 12 mais schématiquement illustrée sur la figure 13, au contact de substrat BKᵢ.

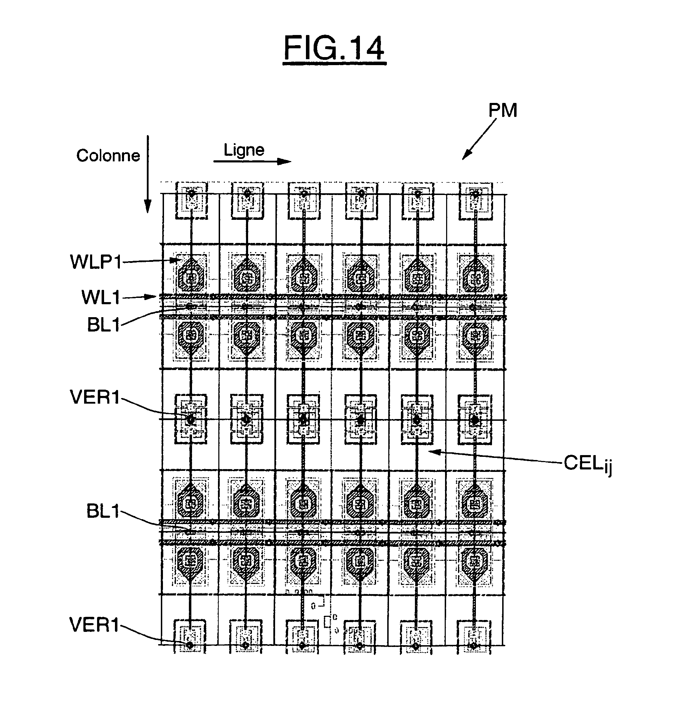

Comme illustré sur les figures 13 et 14, tous les contacts de source des transistors d'accès des cellules d'une même colonne j du plan mémoire sont reliés ensemble par une métallisation de colonne (Bit line), en l'espèce BLj.

Toutes les premières zones actives des cellules d'une même colonne j du plan mémoire sont reliées ensemble par leur contact PC1ⱼ et par l'intermédiaire d'une autre métallisation de colonne VERj.

Tous les contacts de drain, et par conséquent tous les contacts de substrat des transistors à grilles flottantes des cellules d'une même ligne i sont reliés ensemble par une métallisation de ligne WLPi.

Les grilles GRTACSᵢ des transistors d'accès des cellules d'une même ligne i du plan mémoire sont reliées ensemble, et les contacts coorespondants WLᵢ sont également reliés ensemble par une métallisation de ligne WLi.

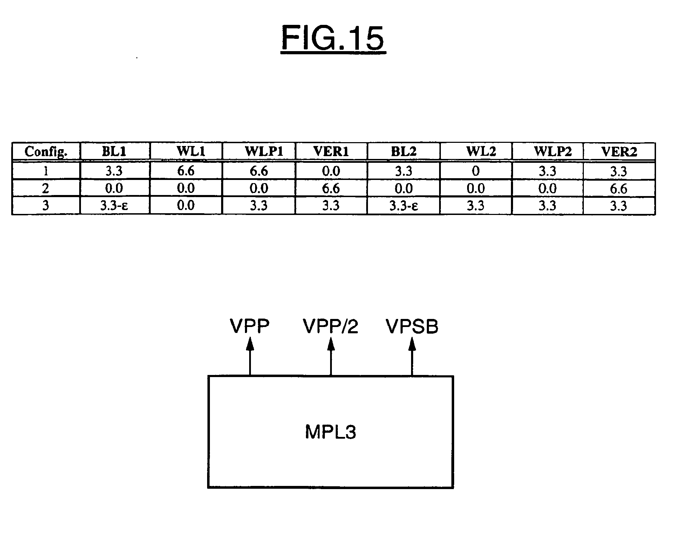

Le dispositif de mémoire comporte en outre des moyens de polarisation MPL3 (figure 15) aptes à sélectionner au moins une cellule-mémoire en programmation et à la programmer par une programmation du type Fowler-Nordheim.

Plus précisément, selon ce mode de réalisation, les moyens de polarisation sont aptes à sélectionner une cellule du plan mémoire et à la programmer en appliquant une différence de potentiel suffisante entre le drain du transistor à grille flottante de la cellule et la première zone active de cette cellule.

Ce n'est donc pas par le transistor d'accès que l'on sélectionne une cellule en programmation.

Un exemple de tensions délivrées par les moyens de polarisation MPL3 et appliquées sur les différentes métallisations du plan mémoire est illustré sur la figure 15 en liaison avec la figure 13.

Plus précisément la configuration 1 du tableau représenté dans le partie haute de la figure 15, correspond à une sélection et à une programmation de la cellule CEL₁₁ de la figure 13.

Dans cet exemple on suppose que la tension d'alimentation VPP du circuit intégré est égale à 6,6 volts, puisque l'épaisseur d'oxyde des transistors des cellules est de l'ordre de 5 nanomètres.

On applique cette tension VPP sur les métallisations WL1 et WLP1, tandis qu'on applique la tension VPP/2 sur les métallisations BL1, BL2, WLP2 et VER2.

Enfin les métallisations VER1 et WL2 sont reliées à la masse.

Il en résulte donc que le transistor d'accès TACS₁ de la cellule CEL₁₁ est bloqué, et que le potentiel de la source du transistor à grille flottante monte également à la tension VPP par couplage, étant donné que le drain et le substrat sont à ce potentiel.

Puisque qu'il existe alors une différence de potentiel importante (typiquement 5,6 volts) entre la grille flottante et le contact PC1₁, la cellule est programmée par une programmation du type Fowler-Nordheim.

Par contre en raison de l'application de la tension VPP/2 sur la métallisation VER2, il n'existe pas une différence de potentiel suffisante entre le drain du transistor à grille flottante de la cellule CEL₁₂ et son contact PC1₂, et par conséquent entre la grille flottante et le contact PC1₂. Les conditions d'une programmation du type Fowler-Nordheim ne sont donc pas remplies.

Les conditions d'une programmation du type Fowler-Nordheim ne sont également pas remplies pour les cellules CEL₂₁ et CEL₂₂.

Les moyens de polarisation MPL3 sont par ailleurs aptes à effacer le plan mémoire dans sa globalité, par exemple en appliquant une tension élevée sur toutes les premières zones actives de toutes les cellules, et en appliquant une tension nulle sur les autres contacts des cellules..

A cet égard ils appliquent par exemple, comme mentionné dans la configuration 2 du tableau de la figure 15, une tension nulle sur les métallisations BL1, WL1, WLP1, BL2, WL2 et WLP2, et la tension VPP sur les métallisations VER1 et VER2. On effectue alors un effacement du type Fowler-Nordheim.

Il convient de noter ici que, tout comme dans la variante illustrée sur les figues 5 et 6, le fait que la source du transistor à grille flottante de la cellule-mémoire soit elle-même flottante, est compatible avec un effacement du type Fowler-Nordheim via la première zone active RG1. En effet, la source flottante du transistor est tirée à la masse par le point-mémoire lui-même.

Les moyens de polarisation MPL3 sont également aptes à lire le plan mémoire par ligne en rendant passants les transistors d'accès des cellules d'une ligne et en rendant bloqués les transistors d'accès des cellules des autres lignes.

Un exemple de tensions appliquées est mentionné dans la configuration 3 du tableau de la figure 15.

Dans tout ce qui vient d'être décrit en relation avec les figures 12 à 15, les moyens de polarisation MPL3 délivrent une tension VPSB nulle sur le contact de substrat PSB.

Bien entendu, dans la variante illustrée sur les figures 12 et 14, on pourra utiliser une isolation du type de celle illustrée sur les figures 1, 2 et 3 pour isoler mutuellement les différentes régions actives RG1, RG2 et RG3 du point-mémoire.

## Revendications

1. Dispositif semiconducteur de mémoire, comprenant une cellule-mémoire non volatile programmable et effaçable électriquement à une seule couche de matériau de grille et comportant un transistor à grille flottante et une grille de commande, **caractérisé par le fait que** les régions de source (S), de drain (D) et de canal du transistor à grille flottante forment la grille de commande et **par le fait que** la cellule-mémoire comporte une zone diélectrique (ZTN) disposée entre une première partie (P1) de la couche de matériau de grille et une première zone active semiconductrice (RG1) électriquement isolée d'une deuxième zone active (RG2) incorporant la grille de commande, cette zone diélectrique formant une zone tunnel (ZTN) pour, lors d'un effacement de la cellule, le transfert vers ladite première zone active des charges stockées dans la grille flottante.

2. Dispositif selon la revendication 1, **caractérisé par le fait que** la valeur capacitive de la zone tunnel (ZTN) est inférieure ou égale à 30% de la valeur capacitive totale entre la couche de matériau de grille et l'ensemble des zones actives de la cellule-mémoire.

3. Dispositif selon la revendication 1 ou 2, **caractérisé par le fait que** le transistor a une grille annulaire (FG), et **par le fait que** la couche de matériau de grille comporte outre ladite grille annulaire (FG) et ladite première partie (P1), une partie de liaison (PL) entre cette première partie et la grille annulaire.

4. Dispositif selon l'une des revendications précédentes, **caractérisé par le fait que** la première zone active (RG1) et la deuxième zone active (RG2) sont électriquement isolées l'une par rapport à l'autre par des jonctions PN destinées à être polarisées en inverse.

5. Dispositif selon la revendication 4, **caractérisé par le fait que** la première zone active (RG1) et la deuxième zone active (RG2) sont électriquement isolées l'une par rapport à l'autre en surface par une région d'isolation (STI).

6. Dispositif selon la revendication 5, **caractérisé par le fait que** la première zone active réalisée dans une première région de substrat (RG1) ayant un premier type de conductivité, **par le fait que** la deuxième zone active est réalisée dans une deuxième région de substrat (RG2) ayant également le premier type de conductivité, **par le fait que** la première région de substrat et la deuxième région de substrat sont séparées par une troisième région de substrat (RG3) ayant un deuxième type de conductivité différent du premier, et **par le fait que** la région d'isolation s'étend entre la première région de substrat et la deuxième région de substrat et comporte un orifice débouchant sur une zone de prise de contact (PSB) de la troisième région semiconductrice.

7. Dispositif selon la revendication 4, **caractérisé par le fait que** la première zone active réalisée dans une première région de substrat (RG1) ayant un premier type de conductivité, **par le fait que** la deuxième zone active est réalisée dans une deuxième région de substrat ayant également le premier type de conductivité, **par le fait que** la première région de substrat et la deuxième région de substrat sont séparées par une troisième région de substrat (RG3) ayant un deuxième type de conductivité différent du premier, et **par le fait que** la couche de matériau de grille (FG, P1, P2) s'étend intégralement au dessus des trois régions de substrat sans chevaucher de région d'isolation (STI).

8. Dispositif selon la revendication 6 ou 7, **caractérisé par le fait que** la première région de substrat (RG1) comporte en surface une zone de prise de contact (PC1) ayant le premier type de conductivité.

9. Dispositif selon la revendication 8, **caractérisé par le fait que** la première région de substrat (RG1) comporte en outre une zone surfacique (ZS) ayant le deuxième type de conductivité et s'étendant autour de ladite zone tunnel, cette zone surfacique (ZS) étant électriquement reliée à ladite zone de prise de contact (PC1).

10. Dispositif selon l'une des revendications précédentes, **caractérisé par le fait que** le transistor est un transistor PMOS.

11. Dispositif selon l'une des revendications précédentes, **caractérisé par le fait qu'**il comporte un plan-mémoire comportant plusieurs cellules-mémoires, chaque cellule-mémoire étant affectée d'un transistor d'accès.

12. Dispositif selon l'une des revendications précédentes, **caractérisé par le fait qu'**il comporte en outre des moyens de polarisation (MPL) possédant un état de programmation de la cellule-mémoire, un état de lecture de la cellule-mémoire, et un état d'effacement de la cellule-mémoire, **par le fait que** dans chacun des états, les moyens de polarisation sont aptes à appliquer des tensions prédéterminées sur la source, le drain et le substrat du transistor et sur la première zone active, et **par le fait que** dans l'état d'effacement les moyens de polarisation provoquent un effacement du type Fowler-Nordheim en appliquant une tension sur la première zone active beaucoup plus élevée que celles appliquées sur les régions de source, de drain et de substrat du transistor.

13. Dispositif selon la revendication 12, **caractérisé par le fait que** dans l'état d'effacement, les moyens de polarisation (MPL) appliquent des tensions égales sur les régions de source, de drain et de substrat du transistor.

14. Dispositif selon l'une des revendications 12 ou 13, **caractérisé par le fait que** dans l'état de programmation, les moyens de polarisation (MPL) provoquent une programmation par porteurs chauds au niveau du transistor.

15. Dispositif selon l'une des revendications 12 ou 13, **caractérisé par le fait que** dans l'état de programmation, les moyens de polarisation (MPL) provoquent une programmation du type Fowler-Nordheim en appliquant sur les régions de source, de drain et de substrat du transistor des tensions égales beaucoup plus élevées que celle appliquée sur la première zone active.

16. Dispositif selon l'une des revendications 12 à 15, **caractérisé par le fait que** dans l'état de lecture, la différence de tension drain/source est limitée à 1 volt en valeur absolue.

17. Dispositif selon la revendication 11, **caractérisé par le fait que** le transistor d'accès (TACSᵢ) affecté à une cellule-mémoire encadrée par deux cellules-mémoires adjacentes situées dans une même colonne que ladite cellule-mémoire considérée comporte un premier transistor d'accès élémentaire (TACSEL1ᵢ) spécifiquement associé à ladite cellule-mémoire et un deuxième (TACSEL2ᵢ) et un troisième (TACSEL3ᵢ) transistor d'accès élémentaires respectivement communs aux deux transistors d'accès respectivement affectés aux deux cellules-mémoires adjacentes, **par le fait que** la source (SLC) du transistor d'accès (TACSᵢ) forme la source du premier transistor d'accès élémentaire tandis que le drain du premier transistor d'accès élémentaire forme une partie de la source du transistor à grille flottante de la cellule-mémoire, et **par le fait que** le dispositif comporte en outre des moyens de polarisation (MPL2) aptes à sélectionner au moins une cellule-mémoire en programmation et en lecture et effacer le plan mémoire par bloc de cellules.

18. Dispositif selon la revendication 17, **caractérisé par le fait que** les moyens de polarisation (MPL2) sont aptes à appliquer une même tension de polarisation de source sur les sources respectives des transistors d'accès affectés respectivement aux cellules-mémoires d'une même colonne, une même tension de polarisation de grille sur les grilles respectives des transistors d'accès affectés respectivement aux cellules-mémoires d'une même colonne, et une même tension d'effacement sur les premières zones actives respectives des cellules-mémoires d'au moins une même colonne.

19. Dispositif selon la revendication 17 ou 18, **caractérisé par le fait que** le transistor d'accès (TACSᵢ) affecté à une cellule-mémoire entoure partiellement le transistor à grille flottante de la cellule-mémoire.

20. Dispositif selon la revendication 19, **caractérisé par le fait que** chaque colonne (CLⱼ) de cellules-mémoires comporte une couche de matériau de grille (MTLⱼ) possédant une partie principale (PMTLⱼ) s'étendant dans le sens de la colonne le long et en vis-à-vis de tous les transistors à grille flottante des cellules, **par le fait que** la grille du premier transistor élémentaire d'un transistor d'accès affecté à une cellule-mémoire comporte la portion de ladite partie principale de la couche de matériau de grille située en vis-à-vis du transistor à grille flottante de ladite cellule, **par le fait que** couche de matériau de grille comporte au niveau de chaque cellule-mémoire, une deuxième portion élémentaire (E2MTLⱼ) raccordée à la partie principale et s'étendant sensiblement perpendiculairement à cette partie principale d'un côté du transistor à grille flottante de la cellule de façon à former une partie de la grille du deuxième transistor élémentaire du transistor d'accès, ainsi qu'une troisième portion élémentaire (E3MTLⱼ) raccordée à la partie principale et s'étendant sensiblement perpendiculairement à cette partie principale de l'autre côté du transistor à grille flottante de la cellule de façon à former une partie de la grille du troisième transistor élémentaire du transistor d'accès, et **par le fait que** ladite deuxième portion élémentaire associée à une cellule-mémoire forme la troisième portion élémentaire associée à l'une des deux cellules-mémoires adjacentes, tandis que ladite troisième portion élémentaire associée à la cellule-mémoire forme la deuxième portion élémentaire associée à l'autre des deux cellules-mémoires adjacentes.

21. Dispositif selon l'une des revendications 17 à 20, **caractérisé par le fait que** les moyens de polarisation (MPL2) possèdent un état de programmation dans lequel ils sont aptes à programmer une cellule-mémoire, un état de lecture dans lequel ils sont aptes à lire une cellule-mémoire, et un état d'effacement dans lequel ils sont aptes à effacer au moins une colonne de cellules-mémoires, **par le fait que** dans chacun des états, les moyens de polarisation sont aptes à appliquer des tensions prédéterminées sur les sources et les grilles des transistor d'accès, ainsi que sur les drains et les substrats des transistors à grilles flottantes des cellules et sur les premières zones actives, et **par le fait que** dans l'état d'effacement les moyens de polarisation provoquent un effacement du type Fowler-Nordheim en appliquant une tension sur les premières zones actives beaucoup plus élevées que celles appliquées sur les régions de source des transistors d'accès, et sur les régions de drain et de substrat des transistors à grilles flottantes.

22. Dispositif selon la revendication 21, **caractérisé par le fait que** pour accéder à une cellule-mémoire en lecture ou en programmation, les moyens de polarisation (MPL2) rendent passants les transistors d'accès des cellules-mémoires appartenant à la même colonne que celle de la cellule-mémoire considérée, appliquent une tension identique sur la source du transistor d'accès et le drain du transistor à grille flottante de chaque cellule-mémoire de ladite colonne différente de la cellule-mémoire considérée, et rendent bloqués les transistors d'accès des cellules-mémoires appartenant une autre colonne que celle de la cellule-mémoire considérée.

23. Dispositif selon la revendication 14 ou l'une des revendications 21 ou 22, **caractérisé par le fait que** les moyens de polarisation (MPL ;MPL2) sont aptes à programmer une cellule-mémoire ayant subi un effacement et dont le transistor est un transistor PMOS, en provoquant une programmation par électrons chauds au niveau du transistor en deux étapes successives (PC1 = 0V ; PC1 = 5V), de façon à d'abord compenser les éventuelles charges positives résiduelles présentes dans la grille flottante puis à effectuer une programmation optimale.

24. Dispositif selon la revendication 23, **caractérisé par le fait que** dans la première étape, les moyens de polarisation (MPL1 ;MPL2) compensent les éventuelles charges positives résiduelles présentes dans la grille flottante en appliquant une tension de compensation (VZ1) sur le contact (PC1) de la première zone active.

25. Dispositif selon la revendication 24, **caractérisé par le fait que** la tension de compensation (VZ1) est inférieure ou égale à 0 volt et supérieure à -500 mV environ.

26. Dispositif selon les revendications 3 et 11, **caractérisé par le fait que** le transistor d'accès affecté (TACS_{¡}) à une cellule-mémoire comporte une grille (GRTACSᵢ) s'étendant perpendiculairement à ladite partie de liaison (PL) et à l'opposé de cette partie de liaison par rapport à la grille annulaire, **par le fait que** la source du transistor d'accès comporte un contact de source (BLⱼ), **par le fait que** le drain du transistor d'accès forme une partie de la source du transistor à grille flottante de la cellule-mémoire, et **par le fait que** le drain du transistor à grille flottante est électriquement relié à la deuxième zone active (RG2).

27. Dispositif selon la revendication 26, **caractérisé par le fait que** tous les contacts de source des transistors d'accès des cellules d'une même colonne du plan mémoire sont reliés ensemble (BL1), **par le fait que** toutes les premières zones actives des cellules d'une même colonne du plan mémoire sont reliées ensemble (VER1), **par le fait que** les grilles des transistors d'accès des cellules d'une même ligne du plan mémoire sont reliées ensemble et les contacts de grille correspondants (WLᵢ) sont reliés ensemble par une métallisation de ligne (WL1), **par le fait que** les drains des transistors à grilles flotantes des cellules d'une même ligne du plan mémoire sont reliées ensemble pour former une autre métallisation de ligne (WLP1), et **par le fait que** le dispositif comporte en outre des moyens de polarisation (MPL3) aptes à sélectionner au moins une cellule-mémoire en programmation et à la programmer par une programmation du type Fowler-Nordheim.

28. Dispositif selon la revendication 27, **caractérisé par le fait que** les moyens de polarisation (MPL3) sont aptes à sélectionner une cellule du plan mémoire et à la programmer en appliquant une différence de potentiel suffisante entre le drain du transistor à grille flottante de la cellule et la première zone active de cette cellule.

29. Dispositif selon la revendication 27 ou 28, **caractérisé par le fait que** les moyens de polarisation (MPL3) sont aptes à effacer le plan mémoire dans sa globalité.

30. Dispositif selon la revendication 29, **caractérisé par le fait que** les moyens de polarisation (MPL3) sont aptes à effacer le plan mémoire dans sa globalité en appliquant une tension élevée sur toutes les premières zones actives de toutes les cellules, et en appliquant une tension nulle sur les autres contacts des cellules.

31. Dispositif selon l'une des revendications 27 à 30, **caractérisé par le fait que** les moyens de polarisation (MPL3) sont aptes à lire le plan mémoire par ligne en rendant passants les transistors d'accès des cellules d'une ligne et en rendant bloqués les transistors d'accès des cellules des autres lignes.

32. Dispositif selon l'une des revendications précédentes, **caractérisé par le fait qu'**il forme une mémoire du type EEPROM ou du type FLASH.

33. Circuit intégré, **caractérisé par le fait qu'**il comporte un dispositif selon l'une des revendications 1 à 32.

## Claims

1. Semiconductor memory device comprising an electrically erasable and programmable non-volatile memory cell having a single layer of gate material and including a floating-gate transistor and a control gate, **characterized in that** the source (S), drain (D) and channel regions of the floating-gate transistor form the control gate and **in that** the memory cell includes a dielectric zone (ZTN) lying between a first part (P1) of the layer of gate material and a first semiconductor active zone (RG1) electrically isolated from a second active zone (RG2) incorporating the control gate, this dielectric zone forming a tunnel zone (ZTN) for transferring, during erasure of the cell, the charges stored in the floating gate to the said first active zone.

2. Device according to Claim 1, **characterized in that** the capacitance of the tunnel zone (ZTN) is less than or equal to 30% of the total capacitance between the layer of gate material and all of the active zones of the memory cell.

3. Device according to Claim 1 or 2, **characterized in that** the transistor has an annular gate (FG) and **in that** the layer of gate material includes, in addition to the said annular gate (FG) and the said first part (P1), a linking part (PL) between this first part and the annular gate.

4. Device according to one of the preceding claims, **characterized in that** the first active zone (RG1) and the second active zone (RG2) are electrically isolated from each other by PN junctions intended to be reverse-biased.

5. Device according to Claim 4, **characterized in that** the first active zone (RG1) and the second active zone (RG2) are electrically isolated from each other on the surface by an isolation region (STI).

6. Device according to Claim 5, **characterized in that** the first active zone (RG1) produced in a first substrate region (RG1) having a first type of conductivity, **in that** the second active zone is produced in a second substrate region (RG2) also having the first type of conductivity, **in that** the first substrate region and the second substrate region are separated by a third substrate region (RG3) having a second type of conductivity, different from the first, and **in that** the isolation region extends between the first substrate region and the second substrate region and includes an aperture emerging in a contact zone (PSB) in the third semiconductor region.

7. Device according to Claim 4, **characterized in that** the first active zone (RG1) produced in a first substrate region (RG1) having a first type of conductivity, **in that** the second active zone is produced in a second substrate region (RG2) also having the first type of conductivity, **in that** the first substrate region and the second substrate region are separated by a third substrate region (RG3) having a second type of conductivity, different from the first, and **in that** the layer of gate material (FG, P1, P2) extends entirely above the three substrate regions without overlapping the isolation region (STI).

8. Device according to Claim 6 or 7, **characterized in that** the first substrate region (RG1) includes, on the surface, a contact zone (PC1) having the first type of conductivity.

9. Device according to Claim 8, **characterized in that** the first substrate region (RG1) furthermore includes a surface zone (ZS) having the second type of conductivity and extending around the said tunnel zone, this surface zone (ZS) being electrically connected to the said contact zone (PC1).

10. Device according to one of the preceding claims, **characterized in that** the transistor is a PMOS transistor.

11. Device according to one of the preceding claims, **characterized in that** it comprises a memory plane having several memory cells, each memory cell being assigned to an access transistor.

12. Device according to one of the preceding claims, **characterized in that** it furthermore includes bias means (MPL) possessing a memory cell programming state, a memory cell read state and a memory cell erase state, **in that** the bias means are capable of applying, in each of the states, predetermined voltages to the source, the drain and the substrate of the transistor and to the first active zone and **in that**, in the erase state, the bias means cause Fowler-Nordheim erasing by applying a voltage to the first active zone much higher than those applied to the source, drain and substrate regions of the transistor.

13. Device according to Claim 12, **characterized in that**, in the erase state, the bias means (MPL) apply equal voltages to the source, drain and substrate regions of the transistor.

14. Device according to either of Claims 12 and 13, **characterized in that**, in the programming state, the bias means (MPL) cause hot-carrier programming within the transistor.

15. Device according to either of Claims 12 and 13, **characterized in that**, in the programming state, the bias means (MPL) cause Fowler-Nordheim programming by applying equal voltages to the source, drain and substrate regions of the transistor that are much higher than that applied to the first active zone.

16. Device according to one of Claims 12 to 15, **characterized in that**, in the read state, the drain/source voltage difference is limited to 1 volt in absolute value.

17. Device according to Claim 11, **characterized in that** the access transistor (TACSᵢ) assigned to a memory cell flanked by two adjacent memory cells that are located in the same column as the said memory cell in question includes a first elementary access transistor (TACSEL1ᵢ) specifically associated with the said memory cell and second (TACSEL2ᵢ) and third (TACSEL3ᵢ) elementary access transistors respectively common to the two access transistors assigned to the two adjacent memory cells respectively, **in that** the source (SLC) of the access transistor (TACSᵢ) forms the source of the first elementary access transistor while the drain of the first elementary access transistor forms part of the source of the floating-gate transistor of the memory cell and **in that** the device furthermore includes bias means (MPL2) capable of selecting at least one memory cell in program mode and in read mode and of erasing the memory plane by blocks of cells.

18. Device according to Claim 17, **characterized in that** the bias means (MPL2) are capable of applying the same source bias voltage to the respective sources of the access transistors assigned to the memory cells of any one column respectively, the same gate bias voltage to the respective gates of the access transistors assigned to the memory cells of the same column respectively and the same erase voltage to the respective first active zones of the memory cells of at least the same column.

19. Device according to Claim 17 or 18, **characterized in that** the access transistor (TACSᵢ) assigned to a memory cell partially surrounds the floating gate transistor of the memory cell.

20. Device according to Claim 19, **characterized in that** each column (CLⱼ) of memory cells has a layer of gate material (MTLⱼ) possessing a main part (PMTLⱼ) extending in the direction of the column along and opposite all the floating-gate transistors of the cells, **in that** the gate of the first elementary transistor of an access transistor assigned to a memory cell includes that portion of the said main part of the layer of gate material which is located opposite the floating-gate transistor of the said cell, **in that** the layer of gate material includes, within each memory cell, a second, elementary portion (E2MTLⱼ) connected to the principal part and extending approximately perpendicular to this principal part on one side of the floating-gate transistor of the cell, so as to form part of the gate of the second elementary transistor of the access transistor, and a third, elementary portion (E3MTLⱼ) connected to the principal part and extending approximately perpendicular to this principal part on the other side of the floating-gate transistor of the cell, so as to form part of the gate of the third elementary transistor of the access transistor, and **in that** the said second elementary portion associated with a memory cell forms the third elementary portion associated with one of the two adjacent memory cells, whereas the said third elementary portion associated with the memory cell forms the second elementary portion associated with the other of the two adjacent memory cells.

21. Device according to one of Claims 17 to 20, **characterized in that** the bias means (MPL2) possess a programming state in which they are capable of programming a memory cell, a read state in which they are capable of reading a memory cell and an erase state in which they are capable of erasing at least one column of memory cells, **in that** the bias means are capable of applying, in each of the states, predetermined voltages to the sources and the gates of the access transistors, and to the drains and the substrates of the floating-gate transistors of the cells and to the first active zones, and **in that**, in the erase state, the bias means cause Fowler-Nordheim erasing by applying a voltage to the first active zones that is much higher than those applied to the source regions of the access transistors, and to the drain and substrate regions of the floating-gate transistors.

22. Device according to Claim 21, **characterized in that**, to access a memory cell in read mode or in programming mode, the bias means (MPL2) turn on the access transistors of the memory cells belonging to the same column as that of the memory cell in question, apply an identical voltage to the source of the access transistor and the drain of the floating-gate transistor of each memory cell of the said column different from the memory cell in question and turn off the access transistors of the memory cells belonging to a column other than that of the memory cell in question.

23. Device according to Claim 14 or either of Claims 21 or 22, **characterized in that** the bias means (MPL; MPL2) are capable of programming a memory cell that has undergone erasure, the transistor of which cell is a PMOS transistor, by carrying out hot-electron programming on the transistor in two successive steps (PC1 = 0 V; PC1 = 5 V) so as firstly to compensate for any residual positive charges present in the floating gate and then to carry out optimum programming.

24. Device according to Claim 23, **characterized in that**, in the first step, the bias means (MPL1; MPL2) compensate for any residual positive charges present in the floating gate by applying a compensation voltage (VZ1) to the contact (PC1) of the first active zone.

25. Device according to Claim 24, **characterized in that** the compensation voltage (VZ1) is less than or equal to 0 volts and greater than about -500 mV.

26. Device according to Claim 3 and 11, **characterized in that** the access transistor (TACSᵢ) assigned to a memory cell comprises a gate (GRTACSᵢ) extending perpendicular to the said linking part (PL) and on the opposite side from this linking part with respect to the annular gate, **in that** the source of the access transistor comprises a source contact (BLⱼ), **in that** the drain of the access transistor forms part of the source of the floating-gate transistor of the memory cell and **in that** the drain of the floating-gate transistor is electrically connected to the second active zone (RG2).

27. Device according to Claim 26, **characterized in that** all the source contacts of the access transistors of the cells of any one column of the memory plane are connected together (BL1), **in that** all the first active zones of the cells of any one column of the memory plane are connected together (VER1), **in that** the gates of the access transistors of the cells of any one line of the memory plane are connected together and the corresponding gate contacts (WLi) are connected together by a line metallization (WL1), **in that** the drains of the floating-gate transistors of the cells of any one line of the memory plane are connected together in order to form another line metallization (WLP1) and **in that** the device furthermore includes bias means (MPL3) capable of selecting at least one memory cell in programming mode and of programming it by Fowler-Nordheim programming.

28. Device according to Claim 27, **characterized in that** the bias means (MPL3) are capable of selecting a cell of the memory plane and of programming it by applying a sufficient potential difference between the drain of the floating-gate transistor of the cell and the first active zone of this cell.

29. Device according to Claim 27 or 28, **characterized in that** the bias means (MPL3) are capable of erasing the memory plane in its entirety.

30. Device according to Claim 29, **characterized in that** the bias means (MPL3) are capable of erasing the memory plane in its entirety by applying a high voltage to all the first active zones of all the cells and by applying a zero voltage to the other contacts of the cells.

31. Device according to one of Claims 27 to 30, **characterized in that** the bias means (MPL3) are capable of reading the memory plane line by line by turning on the access transistors of the cell of a line and by turning off the access transistors of the cells of the other lines.

32. Device according to one of the preceding claims, **characterized in that** it forms a memory of the EEPROM type or the FLASH type.

33. Integrated circuit, **characterized in that** it includes a device according to one of Claims 1 to 32.

## Patentansprüche

1. Halbleiterspeichervorrichtung, mit einer elektrisch löschbaren und programmierbaren nichtflüchtigen Speicherzelle mit einer einzigen Gate-Materialschicht und mit einem Transistor mit schwebendem Gate sowie mit einem Steuergate, **dadurch gekennzeichnet, dass** der Source-Bereich (S), der Drain-Bereich (D) und der Kanal des Transistors mit schwebendem Gate das Steuergate bilden und dass die Speicherzelle eine dielektrische Zone (ZTN) enthält, die zwischen einem ersten Teil (P1) der Gate-Materialschicht und einer ersten aktiven Halbleiterzone (RG1), die von einer das Steuergate enthaltenden zweiten aktiven Zone (RG2) elektrisch isoliert ist, angeordnet ist, wobei diese dielektrische Zone eine Tunnelzone (ZTN) bildet, um bei einer Löschung der Zelle in dem schwebenden Gate gespeicherte Ladungen zu der ersten aktiven Zone zu transportieren.

2. Vorrichtung nach Anspruch 1, **dadurch gekennzeichnet, dass** der kapazitive Wert der Tunnelzone (ZTN) kleiner oder gleich 30 % des gesamten kapazitiven Werts zwischen der Gate-Materialschicht und der Gesamtheit der aktiven Zonen der Speicherzelle ist.

3. Vorrichtung nach Anspruch 1 oder 2, **dadurch gekennzeichnet, dass** der Transistor ein ringförmiges Gate (FG) besitzt und dass die Gate-Materialschicht außer dem ringförmigen Gate (FG) und dem ersten Teil (P1) einen Verbindungsteil (PL) zwischen diesem ersten Teil und dem ringförmigen Gate aufweist.

4. Vorrichtung nach einem der vorhergehenden Ansprüche, **dadurch gekennzeichnet, dass** die erste aktive Zone (RG1) und die zweite aktive Zone (RG2) voneinander durch PN-Übergänge, die dazu vorgesehen sind, entgegengesetzt vorgespannt zu werden, elektrisch isoliert sind.

5. Vorrichtung nach Anspruch 4, **dadurch gekennzeichnet, dass** die erste aktive Zone (RG1) und die zweite aktive Zone (RG2) relativ zueinander an der Oberfläche durch einen Isolationsbereich (STI) elektrisch isoliert sind.

6. Vorrichtung nach Anspruch 5, **dadurch gekennzeichnet, dass** die erste aktive Zone in einem ersten Substratbereich (RG1) verwirklicht ist, der von einem ersten Leitfähigkeitstyp ist, dass die zweite aktive Zone in einem zweiten Substratbereich (RG2) verwirklicht ist, der ebenfalls von dem ersten Leitfähigkeitstyp ist, dass der erste Substratbereich und der zweite Substratbereich durch einen dritten Substratbereich (RG3) getrennt sind, der von einem von dem ersten Leitfähigkeitstyp verschiedenen zweiten Leitfähigkeitstyp ist, und dass sich der Isolationsbereich zwischen dem ersten Substratbereich und dem zweiten Substratbereich erstreckt und eine Öffnung aufweist, die in eine Kontaktherstellungszone (PSB) des dritten Halbleiterbereichs mündet.

7. Vorrichtung nach Anspruch 4, **dadurch gekennzeichnet, dass** die erste aktive Zone in einem ersten Substratbereich (RG1) verwirklicht ist, der von einem ersten Leitfähigkeitstyp ist, dass die zweite aktive Zone in einem zweiten Substratbereich verwirklicht ist, der ebenfalls von dem ersten Leitfähigkeitstyp ist, dass der erste Substratbereich und der zweite Substratbereich durch einen dritten Substratbereich (RG3) getrennt sind, der von einem von dem ersten Leitfähigkeitstyp verschiedenen zweiten Leitfähigkeitstyp ist, und dass sich die Gate-Materialschicht (FG, P1, P2) einteilig über die drei Substratbereiche erstreckt, ohne mit dem Isolationsbereich (STI) zu überlappen.

8. Vorrichtung nach Anspruch 6 oder 7, **dadurch gekennzeichnet, dass** der erste Substratbereich (RG1) an der Oberfläche eine Kontaktherstellungszone (PC1) aufweist, die vom ersten Leitfähigkeitstyp ist.

9. Vorrichtung nach Anspruch 8, **dadurch gekennzeichnet, dass** der erste Substratbereich (RG1) außerdem eine Oberflächenzone (ZS) aufweist, die vom zweiten Leitfähigkeitstyp ist und sich um die Tunnelzone erstreckt, wobei diese Oberflächenzone (ZS) mit der Kontaktherstellungszone (PC1) elektrisch verbunden ist.

10. Vorrichtung nach einem der vorhergehenden Ansprüche, **dadurch gekennzeichnet, dass** der Transistor ein PMOS-Transistor ist.

11. Vorrichtung nach einem der vorhergehenden Ansprüche, **dadurch gekennzeichnet, dass** sie eine Speicherebene enthält, die mehrere Speicherzellen besitzt, wobei jeder Speicherzelle ein Zugriffstransistor zugewiesen ist.

12. Vorrichtung nach einem der vorhergehenden Ansprüche, **dadurch gekennzeichnet, dass** sie außerdem Vorspannungsmittel (MPL) enthält, die einen Zustand zum Programmieren der Speicherzelle, einen Zustand zum Lesen der Speicherzelle und einen Zustand zum Löschen der Speicherzelle besitzen, dass in jedem der Zustände die Vorspannungsmittel an die Source, den Drain und das Substrat des Transistors und an die erste aktive Zone vorgegebene Spannungen anlegen können und dass im Löschzustand die Vorspannungsmittel eine Löschung des Fowler-Nordheim-Typs hervorrufen, indem sie an die erste aktive Zone eine Spannung anlegen, die viel höher als jene ist, die an die Bereiche der Source, des Drains und des Substrats des Transistors angelegt werden.

13. Vorrichtung nach Anspruch 12, **dadurch gekennzeichnet, dass** im Löschzustand die Vorspannungsmittel (MPL) an die Bereiche der Source, des Drains und des Substrats des Transistors gleiche Spannungen anlegen.

14. Vorrichtung nach einem der Ansprüche 12 oder 13, **dadurch gekennzeichnet, dass** im Programmierzustand die Vorspannungsmittel (MPL) eine Programmierung durch heiße Träger auf Seiten des Transistors hervorrufen.

15. Vorrichtung nach einem der Ansprüche 12 oder 13, **dadurch gekennzeichnet, dass** im Programmierzustand die Vorspannungsmittel (MPL) eine Programmierung des Fowler-Nordheim-Typs hervorrufen, indem sie an die Bereiche der Source, des Drains und des Substrats des Transistors gleiche Spannungen anlegen, die viel höher als jene sind, die an die erste aktive Zone angelegt wird.

16. Vorrichtung nach einem der Ansprüche 12 bis 15, **dadurch gekennzeichnet, dass** im Lesezustand der Unterschied zwischen der Drain-/Source-Spannung auf einen Absolutwert von 1 Volt begrenzt ist.

17. Vorrichtung nach Anspruch 11, **dadurch gekennzeichnet, dass** der Zugriffstransistor (TACSᵢ), der einer Speicherzelle zugewiesen ist, die von zwei benachbarten Speicherzellen eingerahmt ist, die sich in derselben Spalte wie die betrachtete Speicherzelle befinden, einen ersten elementaren Zugriffstransistor (TACSEL1ᵢ), der speziell dieser Speicherzelle zugeordnet ist, und einen zweiten elementaren Zugriffstransistor (TACSEL2ᵢ) sowie einen dritten elementaren Zugriffstransistor (TACSEL3ᵢ), die den zwei Zugriffstransistoren gemeinsam sind, die den zwei entsprechenden benachbarten Speicherzellen zugewiesen sind, enthält, dass die Source (SLC) des Zugriffstransistors (TACSᵢ) die Source des ersten elementaren Zugriffstransistors bildet, während der Drain des ersten elementaren Zugriffstransistors einen Teil der Source des Transistors mit schwebendem Gate der Speicherzelle bildet, und dass die Vorrichtung außerdem Vorspannungsmittel (MPL2) enthält, die wenigstens eine Speicherzelle zur Programmierung und zum Lesen auswählen können und die Speicherebene zellenblockweise löschen können.

18. Vorrichtung nach Anspruch 17, **dadurch gekennzeichnet, dass** die Vorspannungsmittel (MPL2) dieselbe Source-Vorspannung an die jeweiligen Sources der Zugriffstransistoren anlegen können, die den jeweiligen Speicherzellen derselben Spalte zugewiesen sind, dieselbe Gate-Vorspannung an die jeweiligen Gates der Zugriffstransistoren anlegen können, die den jeweiligen Speicherzellen derselben Spalte zugewiesen sind, und dieselbe Löschspannung an die ersten aktiven Zonen der Speicherzellen wenigstens einer Spalte anlegen können.

19. Vorrichtung nach Anspruch 17 oder 18, **dadurch gekennzeichnet, dass** der Zugriffstransistor (TACSᵢ), der einer Speicherzelle zugewiesen ist, den Transistor mit schwebendem Gate dieser Speicherzelle teilweise umgibt.

20. Vorrichtung nach Anspruch 19, **dadurch gekennzeichnet, dass** jede Spalte (CLⱼ) von Speicherzellen eine Gate-Materialschicht (MTLⱼ) aufweist, die einen Hauptteil (PMTLⱼ) besitzt, der sich in Richtung der Spalte längs der und gegenüber den Transistoren mit schwebendem Gate der Zellen erstreckt, dass das Gate des ersten elementaren Transistors eines Zugriffstransistors, der einer Speicherzelle zugewiesen ist, den Abschnitt des Hauptteils der Gate-Materialschicht aufweist, der sich gegenüber dem Transistor mit schwebendem Gate dieser Zelle befindet, dass eine Gate-Materialschicht auf Seiten jeder Speicherzelle einen zweiten elementaren Abschnitt (E2MTLⱼ) enthält, der mit dem Hauptteil verbunden ist und sich im Wesentlichen senkrecht zu diesem Hauptteil auf einer Seite des Transistors mit schwebendem Gate der Zelle erstreckt, derart, dass ein Teil des Gates des zweiten elementaren Transistors des Zugriffstransistors gebildet wird, sowie einen dritten elementaren Abschnitt (E3MTLⱼ) enthält, der mit dem Hauptteil verbunden ist und sich im Wesentlichen senkrecht zu diesem Hauptteil auf der anderen Seite des Transistors mit schwebendem Gate der Zelle erstreckt, derart, dass ein Teil des Gates des dritten elementaren Transistors des Zugriffstransistors gebildet wird, und dass der zweite elementare Abschnitt, der einer Speicherzelle zugeordnet ist, den dritten elementaren Abschnitt bildet, der einer der zwei benachbarten Speicherzellen zugeordnet ist, während der dritte elementare Abschnitt, der der Speicherzelle zugeordnet ist, den zweiten elementaren Abschnitt bildet, der der anderen der zwei benachbarten Speicherzellen zugeordnet ist.

21. Vorrichtung nach einem der Ansprüche 17 bis 20, **dadurch gekennzeichnet, dass** die Vorspannungsmittel (MPL2) einen Programmierzustand besitzen, in dem sie eine Speicherzelle programmieren können, einen Lesezustand besitzen, in dem sie eine Speicherzelle lesen können, und einen Löschzustand besitzen, in dem sie wenigstens eine Spalte von Speicherzellen löschen können, dass in jedem der Zustände die Vorspannungsmittel vorgegebene Spannungen an die Sources und die Gates der Zugriffstransistoren sowie an die Drains und die Substrate der Transistoren mit schwebenden Gates der Zellen und an die ersten aktiven Zonen anlegen können und dass im Löschzustand die Vorspannungsmittel eine Löschung des Fowler-Nordheim-Typs hervorrufen, indem sie an die ersten aktiven Zonen eine Spannung anlegen, die viel höher ist als jene, die an die Source-Bereiche der Zugriffstransistoren und an die Drain- und SubstratBereiche der Transistoren mit schwebendem Gate angelegt werden.

22. Vorrichtung nach Anspruch 21, **dadurch gekennzeichnet, dass** die Vorspannungsmittel (MPL2), um auf eine Speicherzelle zum Lesen oder zum Programmieren zuzugreifen, die Zugriffstransistoren der Speicherzellen, die zur selben Spalte wie jene der betrachteten Speicherzelle gehören, durchschalten, an die Source des Zugriffstransistors und an den Drain des Transistors mit schwebendem Gate jeder Speicherzelle der Spalte, die von der betrachteten Speicherzelle verschieden ist, dieselbe Spannung anlegen und die Zugriffstransistoren der Speicherzellen, die zu einer anderen Spalte als jener der betrachteten Speicherzelle gehören, sperren.

23. Vorrichtung nach Anspruch 14 oder nach einem der Ansprüche 21 oder 22, **dadurch gekennzeichnet, dass** die Vorspannungsmittel (MPL; MPL2) eine Speicherzelle programmieren können, die einer Löschung unterworfen worden ist und deren Transistor ein PMOS-Transistor ist, indem sie eine Programmierung durch heiße Elektronen auf Seiten des Transistors in zwei aufeinander folgenden Schritten (PC1 = 0 V; PC1 = 5 V) hervorrufen, derart, dass zunächst die eventuellen positiven Restladungen, die in dem schwebenden Gate vorhanden sind, kompensiert werden und dann eine optimale Programmierung ausgeführt wird.

24. Vorrichtung nach Anspruch 23, **dadurch gekennzeichnet, dass** im ersten Schritt die Vorspannungsmittel (MPL1; MPL2) die eventuellen positiven Restladungen, die in dem schwebenden Gate vorhanden sind, kompensieren, indem sie an den Kontakt (PC1) der ersten aktiven Zone eine Kompensationsspannung (VZ1) anlegen.

25. Vorrichtung nach Anspruch 24, **dadurch gekennzeichnet, dass** die Kompensationsspannung (VZ1) kleiner oder gleich 0 Volt und größer als etwa -500 mV ist.

26. Vorrichtung nach den Ansprüchen 3 bis 11, **dadurch gekennzeichnet, dass** der einer Speicherzelle zugewiesene Zugriffstransistor (TACSᵢ) ein Gate (GRTACSᵢ) aufweist, das sich senkrecht zu dem Verbindungsteil (PL) und gegenüber diesem Verbindungsteil in Bezug auf das ringförmige Gate erstreckt, dass die Source des Zugriffstransistors einen Source-Kontakt (BLⱼ) aufweist, dass der Drain des Zugriffstransistors einen Teil der Source des Transistors mit schwebendem Gate der Speicherzelle bildet und dass der Drain des Transistors mit schwebendem Gate mit der zweiten aktiven Zone (RG2) elektrisch verbunden ist.

27. Vorrichtung nach Anspruch 26, **dadurch gekennzeichnet, dass** alle Source-Kontakte der Zugriffstransistoren der Zellen derselben Spalte der Speicherebene miteinander verbunden sind (BL1), dass alle aktiven ersten Zonen der Zellen derselben Spalte der Speicherebene miteinander verbunden sind (VER1), dass die Gates der Zugriffstransistoren der Zellen derselben Zeile der Speicherebene miteinander verbunden sind und dass die entsprechenden Gate-Kontakte (WLᵢ) durch eine Zeilenmetallisierung (WL1) miteinander verbunden sind, dass die Drains der Transistoren mit schwebenden Gates der Zellen derselben Zeile der Speicherebene miteinander verbunden sind, um eine andere Zeilenmetallisierung (WLP1) zu bilden, und dass die Vorrichtung außerdem Vorspannungsmittel (MPL3) enthält, die wenigstens eine Speicherzelle zur Programmierung auswählen können und sie durch eine Programmierung des Fowler-Nordheim-Typs programmieren können.

28. Vorrichtung nach Anspruch 27, **dadurch gekennzeichnet, dass** die Vorspannungsmittel (MPL3) eine Zelle der Speicherebene auswählen können und sie durch Anlegen einer ausreichenden Potentialdifferenz zwischen dem Drain des Transistors mit schwebendem Gate der Zelle und der ersten aktiven Zone dieser Zelle programmieren können.

29. Vorrichtung nach Anspruch 27 oder 28, **dadurch gekennzeichnet, dass** die Vorspannungsmittel (MPL3) die Speicherebene als Ganzes löschen können.

30. Vorrichtung nach Anspruch 29, **dadurch gekennzeichnet, dass** die Vorspannungsmittel (MPL3) die Speicherebene als Ganzes löschen können, indem sie an alle ersten aktiven Zonen aller Zellen eine hohe Spannung anlegen und indem sie an die anderen Kontakte der Zellen eine Nullspannung anlegen.

31. Vorrichtung nach einem der Ansprüche 27 bis 30, **dadurch gekennzeichnet, dass** die Vorspannungsmittel (MPL3) die Speicherebene zeilenweise lesen können, indem sie die Zugriffstransistoren der Zellen einer Zeile durchschalten und indem sie die Zugriffstransistoren der Zellen der anderen Zeilen sperren.

32. Vorrichtung nach einem der vorhergehenden Ansprüche, **dadurch gekennzeichnet, dass** sie einen Speicher des EEPROM-Typs oder des FLASH-Typs bildet.

33. Integrierte Schaltung, **dadurch gekennzeichnet, dass** sie eine Vorrichtung nach einem der Ansprüche 1 bis 32 enthält.
